# EUROPEAN PATENT APPLICATION

(11) **EP 4 492 945 A1**
(43) Date of publication of application: **15.01.2025**
(21) Application number: 24186879.3
(22) Date of filing: 05.07.2024
(51) Int. Cl.: H10K 59/126, H01L 27/12, H10K 59/131

(54) **DISPLAY DEVICE**

(30) Priority: 11.07.2023 KR 20230089580
(71) Applicant: Samsung Display Co., Ltd., Gyeonggi-do 17113 (KR)
(72) Inventor: SONG, HEERIM, 17113 Yongin-si (KR); YOON, SOIL, 17113 Yongin-si (KR); LEE, KYUNGHOE, 17113 Yongin-si (KR); LEE, CHEOL-GON, 17113 Yongin-si (KR); JEON, MUKYUNG, 17113 Yongin-si (KR)
(74) Representative: Taor, Simon Edward William

(57) **Abstract**

Disclosed is a display device which includes a first-first line that extends in a first direction, a first-second line that extends in a second direction crossing the first direction and that is connected to the first-first line, a data line that extends in the first direction and that is connected to the first-second line, a pixel connected to the data line, a receiving line that extends in the first direction, a sensor connected to the receiving line, and a shielding electrode that overlaps the first-second line and the receiving line.

## Description

### CROSS-REFERENCE TO RELATED APPLICATIONS

This application claims priority to Korean Patent Application No. 10-2023-0089580 filed on July 11, 2023 in the Korean Intellectual Property Office.

### BACKGROUND

Embodiments of the present disclosure described herein relate to a display device.

An electronic device, such as a smart phone, a digital camera, a notebook computer, a car navigation unit, a smart television, or the like often includes a display device for displaying an image. The display device includes a display panel for generating an image, an input device such as an input sensing unit, a camera for taking an external image, and various sensors.

The input sensing unit is disposed on the display panel and senses a input from the user. The sensors may include a fingerprint sensor, a proximity sensor, and an illuminance sensor. Among the sensors, the fingerprint sensor senses a fingerprint on the display panel. The fingerprint sensor is manufactured as a separate module and disposed in the display device.

### SUMMARY

Embodiments of the present disclosure provide a display device for improving the sensing sensitivity of a sensor.

According to an embodiment, a display device includes a first-first line extending in a first direction, a first-second line extending in a second direction crossing the first direction and that is connected to the first-first line, a data line that extends in the first direction and that is connected to the first-second line, a pixel connected to the data line, a receiving line that extends in the first direction, a sensor connected to the receiving line, and a shielding electrode that is disposed above the first-second line and that overlaps the first-second line and the receiving line.

According to an embodiment, a display device includes a first-first line that extends in a first direction, a first-second line that extends in a second direction crossing the first direction and that is disposed below the first-first line and connected to the first-first line, a data line that extends in the first direction and that is disposed in the same layer as the first-first line and connected to the first-second line, a pixel connected to the data line, a receiving line that extends in the first direction and that is disposed in a layer different from the layer in which the data line is disposed, a sensor connected to the receiving line, and a shielding electrode that disposed above the first-second line and that overlaps the first-second line.

According to an embodiment, a display device includes a first-first line, a first-second line that crosses the first-first line and that is connected to the first-first line, a data line that crosses the first-second line and that is connected to the first-second line, a pixel connected to the data line, a receiving line disposed in a layer different from a layer in which the first-second line is disposed, a sensor connected to the receiving line, and a plurality of shielding electrodes that are disposed in a layer between the first-second line and the receiving line and that overlap the first-second line.

According to an aspect, there is provided a display device comprising: a first-first line extending in a first direction; a first-second line extending in a second direction crossing the first direction and connected to the first-first line; a data line extending in the first direction and connected to the first-second line; a pixel connected to the data line; a receiving line extending in the first direction; a sensor connected to the receiving line; and a shielding electrode disposed above the first-second line and overlapping the first-second line and the receiving line.

In some embodiments, the first-first line and the data line are disposed in the same layer, and the receiving line is disposed on a layer below the first-first line and the data line.

In some embodiments, the first-second line is disposed below the receiving line.

In some embodiments, the shielding electrode is disposed in a layer located between the receiving line and the first-second line.

In some embodiments, the display device further comprises: a plurality of first-first connecting electrodes disposed over the first-second line and connected to the first-second line; and a plurality of second-first connecting electrodes disposed above the first-first connecting electrodes and connected to the first-first connecting electrodes, wherein the data line and the first-first line are connected to the second-first connecting electrodes.

In some embodiments, the display device further comprises: a plurality of first-second connecting electrodes disposed above the first-second line and connected to the first-second line; a plurality of second-second connecting electrodes disposed above the first-second connecting electrodes and connected to the first-second connecting electrodes; a plurality of third-first connecting electrodes extending from the data line and the first-first line, the plurality of third-first connecting electrodes being disposed above the second-first connecting electrodes and connected to the second-first connecting electrodes; and a plurality of third-second connecting electrodes disposed above the second-second connecting electrodes and connected to the second-second connecting electrodes.

In some embodiments, the display device further comprises: a plurality of first-third connecting electrodes disposed above the first-second line and connected to the first-second line, wherein the second-first and second-second connecting electrodes and the third-first and third-second connecting electrodes are not disposed above the first-third connecting electrodes.

In some embodiments, the shielding electrode is disposed in the same layer as the first-first, first-second, and first-third connecting electrodes, the receiving line is disposed in the same layer as the second-first and second-second connecting electrodes, and the data line and the first-first line are disposed in the same layer as the third-first and third-second connecting electrodes.

In some embodiments, the shielding electrode includes a plurality of first shielding electrodes disposed between the first-first, first-second, and first-third connecting electrodes.

In some embodiments, the display device further comprises: an initialization line connected to the pixel, wherein the shielding electrode protrudes from the initialization line.

In some embodiments, the display device further comprises: a reset line disposed above the receiving line and adjacent to the data line.

In some embodiments, the display device further comprises: a plurality of first-first connecting electrodes disposed above the first-second line and connected to the first-second line; a plurality of first-second connecting electrodes disposed above the first-second line; a plurality of second-first connecting electrodes disposed above the first-first connecting electrodes and connected to the first-first connecting electrodes; a plurality of second-second connecting electrodes disposed above the first-second connecting electrodes and connected to the first-second connecting electrodes; and a first power line adjacent to the second-second connecting electrodes, the first power line being integrally formed with the second-second connecting electrodes, wherein the data line and the first-first line are connected to the second-first connecting electrodes.

In some embodiments, the first-second connecting electrodes are spaced apart from the first-second line.

In some embodiments, the display device further comprises: a second-first line extending in the first direction; and a second-second line extending in the second direction and connected to the second-first line, wherein the second-second line is connected to the receiving line.

In some embodiments, the display device further comprises: a plurality of first-fourth connecting electrodes disposed above the second-second line and connected to the second-second line; and a plurality of second-third connecting electrodes disposed above the first-fourth connecting electrodes and connected to the first-fourth connecting electrodes, wherein the receiving line is disposed in the same layer as the second-third connecting electrodes, and wherein among the second-third connecting electrodes, a second-third connecting electrode corresponding to the receiving line extends from the receiving line.

In some embodiments, the display device further comprises: a plurality of first-fifth connecting electrodes disposed above the second-second line and connected to the second-second line; a plurality of first-sixth connecting electrodes disposed above the second-second line and connected to the second-second line; a plurality of second-fourth connecting electrodes disposed above the first-fifth connecting electrodes and connected to the first-fifth connecting electrodes; a plurality of third-third connecting electrodes disposed above the second-third connecting electrodes and connected to the second-third connecting electrodes; and a plurality of third-fourth connecting electrodes disposed above the second-fourth connecting electrodes and connected to the second-fourth connecting electrodes, wherein the second-first line is disposed in the same layer as the third-third connecting electrodes, and wherein among the third-third connecting electrodes, a third-third connecting electrode connected to a second-third connecting electrode not extending from the receiving line extends from the second-first line.

In some embodiments, the shielding electrode includes a plurality of second shielding electrodes disposed between the first-fourth, first-fifth, and first-sixth connecting electrodes.

In some embodiments, the display device further comprises: a plurality of first-fourth connecting electrodes disposed above the second-second line and connected to the second-second line; a plurality of first-fifth connecting electrodes disposed above the second-second line and spaced apart from the second-second line; a plurality of second-third connecting electrodes disposed above the first-fourth connecting electrodes and connected to the first-fourth connecting electrodes; a plurality of second-fourth connecting electrodes disposed above the first-fifth connecting electrodes and connected to the first-fifth connecting electrodes; and a first power line adjacent to the second-fourth connecting electrodes, the first power line being integrally formed with the second-fourth connecting electrodes, wherein the receiving line is disposed in the same layer as the second-third connecting electrodes, wherein among the second-third connecting electrodes, a second-third connecting electrode corresponding to the receiving line extends from the receiving line, and wherein the second-first line is connected to a second-third connecting electrode that is spaced apart from the receiving line.

According to an aspect, there is provided a display device comprising: a first-first line extending in a first direction; a first-second line extending in a second direction crossing the first direction, the first-second line being disposed below the first-first line and connected to the first-first line; a data line extending in the first direction, the data line being disposed in the same layer as the first-first line and connected to the first-second line; a pixel connected to the data line; a receiving line extending in the first direction and disposed in a layer different from the layer in which the data line is disposed; a sensor connected to the receiving line; and a shielding electrode disposed above the first-second line and overlapping the first-second line.

According to an aspect, there is provided a display device comprising: a first-first line; a first-second line crossing the first-first line and connected to the first-first line; a data line crossing the first-second line and connected to the first-second line; a pixel connected to the data line; a receiving line disposed in a layer different from a layer in which the first-second line is disposed; a sensor connected to the receiving line; and a plurality of shielding electrodes disposed in a layer between the first-second line and the receiving line and overlapping the first-second line.

According to an aspect, there is provided a display device as set out in claim 1. Additional features are set out in claims 2 to 14. According to an aspect, there is provided a display device as set out in claim 15.

### BRIEF DESCRIPTION OF THE FIGURES

The above and other objects and features of the present disclosure will become apparent by describing in detail embodiments thereof with reference to the accompanying drawings.
FIG. 1 is a perspective view of a display device according to an embodiment of the present disclosure.
FIG. 2 is a sectional view of the display device illustrated in FIG. 1.
FIG. 3 is a sectional view of a display panel illustrated in FIG. 2.
FIG. 4 is a plan view of the display panel illustrated in FIG. 2.
FIG. 5 is view illustrating an equivalent circuit diagram of one pixel among pixels illustrated in FIG. 4 and a sensor adjacent to the pixel.
FIG. 6 is a sectional view illustrating a light emitting element, a first transistor, a fourth transistor, and a sixth transistor of the pixel illustrated in FIG. 5.
FIG. 7 is a sectional view illustrating a light receiving element, a first transistor, and a second transistor of the sensor illustrated in FIG. 5.
FIG. 8 is a view illustrating a planar arrangement state of light emitting elements and light receiving elements disposed in a partial area of a display region illustrated in FIG. 4.
FIG. 9 is a view illustrating a fingerprint sensing state by sensors illustrated in FIGS. 5 and 7.
FIG. 10 is a plan view illustrating a connection state of data lines and vertical and horizontal lines for the border of the display panel illustrated in FIG. 4.
FIG. 11 is a plan view illustrating a connection state of receiving lines and vertical and horizontal lines for the border of the display panel illustrated in FIG. 4.
FIGS. 12A to 12I are views illustrating planar structures of pixel circuits and sensor circuits step by step.
FIG. 13 is a view illustrating a sectional configuration of a first horizontal line and electrodes connected to the first horizontal line illustrated in FIG. 12I.
FIGS. 14A to 14D are views illustrating planar structures of pixel circuits and sensor circuits step by step.
FIG. 15 is a view illustrating a sectional configuration of a second horizontal line and electrodes connected to the second horizontal line illustrated in FIG. 14D.
FIGS. 16A to 16D are views illustrating a modified embodiment of a layout illustrated in FIGS. 12A to 12I.
FIG. 17 is a view illustrating a sectional configuration of a first horizontal line and electrodes connected to the first horizontal line illustrated in FIG. 16D.
FIGS. 18A to 18C are views illustrating a modified embodiment of the layout illustrated in FIGS. 12A to 12I.
FIG. 19 is a view illustrating a sectional configuration of a first horizontal line and electrodes connected to the first horizontal line illustrated in FIG. 18C.
FIGS. 20A to 20D are views illustrating a modified embodiment of a layout illustrated in FIGS. 14A to 14D.
FIG. 21 is a view illustrating a sectional configuration of a second horizontal line and electrodes connected to the second horizontal line illustrated in FIG. 20D.
FIGS. 22A to 22C are views illustrating a modified embodiment of the layout illustrated in FIGS. 14A to 14D.
FIG. 23 is a view illustrating a sectional configuration of a second horizontal line and electrodes connected to the second horizontal line illustrated in FIG. 22C.

### DETAILED DESCRIPTION

In this specification, when it is mentioned that a component (or, an area, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description.

As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts are described based on orientations and directions in the drawing.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Hereinafter, embodiments of the present disclosure will be described with reference to the accompanying drawings.

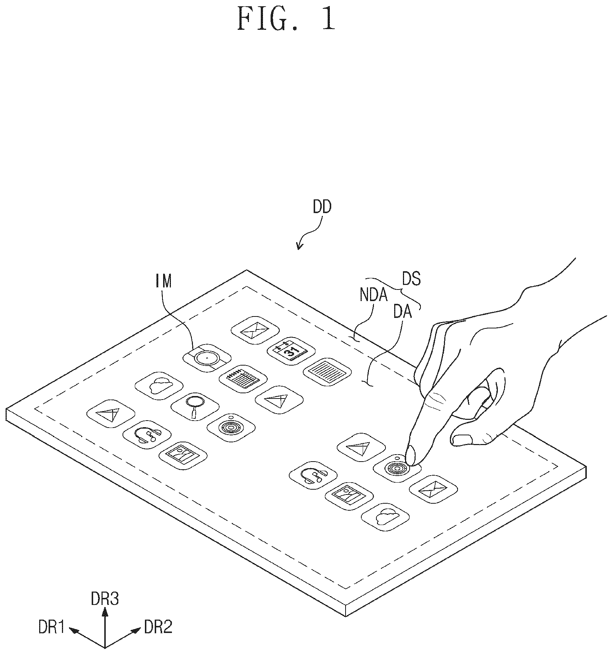

FIG. 1 is a perspective view of a display device according to an embodiment of the present disclosure.

Referring to FIG. 1, the display device DD according to an embodiment of the present disclosure may have a rectangular shape with long sides extending in a first direction DR1 and short sides extending in a second direction DR2 crossing the first direction DR1. However, without being limited thereto, the display device DD may have various shapes such as a circular shape, a polygonal shape, and the like.

Hereinafter, a direction substantially vertically crossing a plane defined by the first direction DR1 and the second direction DR2 is defined as a third direction DR3. As used herein, the expression "when viewed from above the plane" may mean that it is viewed in the third direction DR3.

An upper surface of the display device DD may be defined as a display surface DS and may have a plane defined by the first direction DR1 and the second direction DR2. Images IM generated by the display device DD may be provided to a user through the display surface DS.

The display surface DS may include a display region DA and a non-display region NDA around the display region DA. The display region DA may display an image, and the non-display region NDA may not display an image. The non-display region NDA may surround the display region DA and may define the border of the display device DD that is printed in a predetermined color.

The display device DD may be used in large electronic devices such as a television, a monitor, or a billboard. In addition, the display device DD may be used in small and medium-sized electronic devices such as a personal computer, a notebook computer, a personal digital terminal, a car navigation unit, a game machine, a smart phone, a tablet computer, and a camera. However, these electronic devices are merely illustrative, and the display device DD may be used in other electronic devices without departing from the scope of the present disclosure.

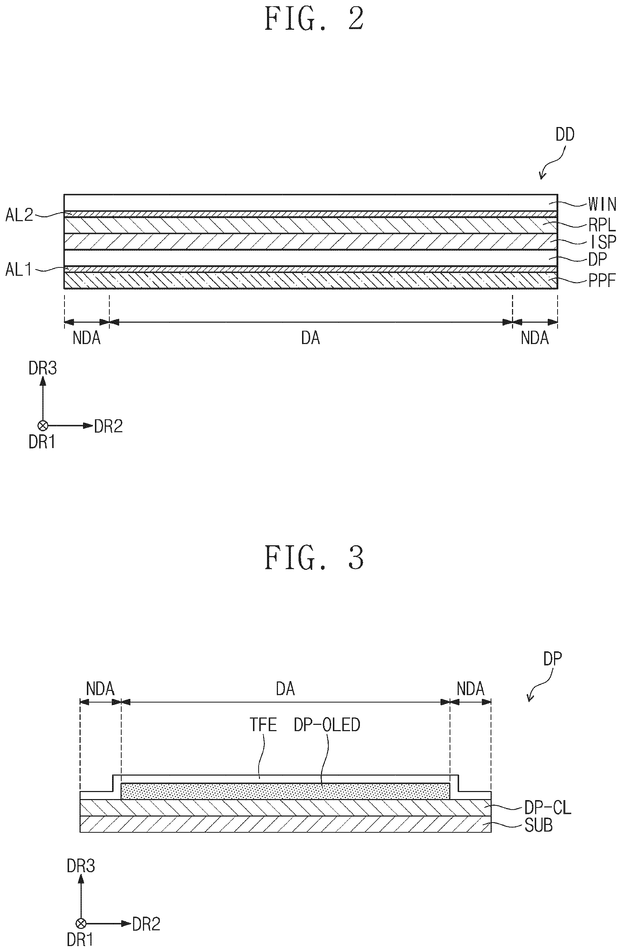

FIG. 2 is a sectional view of the display device illustrated in FIG. 1.

In FIG. 2, a section of the display device DD viewed in the first direction DR1 is illustrated.

Referring to FIG. 2, the display device DD may include a display panel DP, an input sensing unit ISP, an anti-reflective layer RPL, a window WIN, a panel protection film PPF, and first and second adhesive layers AL1 and AL2.

The display panel DP may be a flexible display panel. The display panel DP according to an embodiment of the present disclosure may be an emissive display panel, but embodiments are not particularly limited. For example, the display panel DP may be an organic light emitting display panel or an inorganic light emitting display panel. An emissive layer of the organic light emitting display panel may include an organic light emitting material. An emissive layer of the inorganic light emitting display panel may include quantum dots, quantum rods, and the like. Hereinafter, description will be based on an example embodiment where the display panel DP is an organic light emitting display panel.

The input sensing unit ISP may be disposed on the display panel DP. The input sensing unit ISP may include a plurality of sensing units (not illustrated) for sensing an external input in a capacitive type. The input sensing unit ISP may be directly manufactured on the display panel DP when the display device DD is manufactured. However, without being limited thereto, the input sensing unit ISP may be manufactured as a panel separate from the display panel DP and may be attached to the display panel DP by an adhesive layer.

The anti-reflective layer RPL may be disposed on the input sensing unit ISP. The anti-reflective layer RPL may be directly manufactured on the input sensing unit ISP when the display device DD is manufactured. However, without being limited thereto, the anti-reflective layer RPL may be manufactured as a separate panel and may be attached to the input sensing unit ISP by an adhesive layer.

The anti-reflective layer RPL may be defined as a film for preventing reflection of external light. The anti-reflective layer RPL may decrease the reflectance of external light incident toward the display panel DP from above the display device DD. Due to the anti-reflective layer RPL, the external light may not be visible to the user.

When external light travelling toward the display panel DP is reflected from the display panel DP and provided back to the user, the user may visually recognize the external light as in a mirror. To prevent such a phenomenon, the anti-reflective layer RPL may include a plurality of color filters that display the same colors as those of pixels of the display panel DP.

The color filters may filter external light into the same colors as those of the pixels. In this case, the external light may not be visible to the user. However, without being limited thereto, the anti-reflective layer RPL may include a phase retarder and/or a polarizer to decrease the reflectance of the external light.

The window WIN may be disposed on the anti-reflective layer RPL. The window WIN may protect the display panel DP, the input sensing unit ISP, and the anti-reflective layer RPL from external scratches and impacts.

The panel protection film PPF may be disposed under the display panel DP. The panel protection film PPF may protect a lower portion of the display panel DP. The panel protection film PPF may include a flexible plastic material such as polyethylene terephthalate (PET).

The first adhesive layer AL1 may be disposed between the display panel DP and the panel protection film PPF, and the display panel DP and the panel protection film PPF may be bonded to each other by the first adhesive layer AL1. The second adhesive layer AL2 may be disposed between the window WIN and the anti-reflective layer RPL, and the window WIN and the anti-reflective layer RPL may be bonded to each other by the second adhesive layer AL2.

FIG. 3 is a sectional view of the display panel illustrated in FIG. 2.

In FIG. 3, a section of the display panel DP viewed in the first direction DR1 is illustrated.

Referring to FIG. 3, the display panel DP may include a substrate SUB, a circuit element layer DP-CL disposed on the substrate SUB, a display element layer DP-OLED disposed on the circuit element layer DP-CL, and a thin film encapsulation layer TFE disposed on the display element layer DP-OLED.

The substrate SUB may include a display region DA and a non-display region NDA around the display region DA. The substrate SUB may include a flexible plastic material such as glass or polyimide (PI). The display element layer DP-OLED may be disposed on the display region DA.

A plurality of pixels may be disposed in the circuit element layer DP-CL and the display element layer DP-OLED. Each of the pixels may include transistors disposed in the circuit element layer DP-CL and a light emitting element disposed in the display element layer DP-OLED and connected to the transistors.

The thin film encapsulation layer TFE may be disposed on the circuit element layer DP-CL to cover the display element layer DP-OLED. The thin film encapsulation layer TFE may protect the pixels from moisture, oxygen, and external foreign matter.

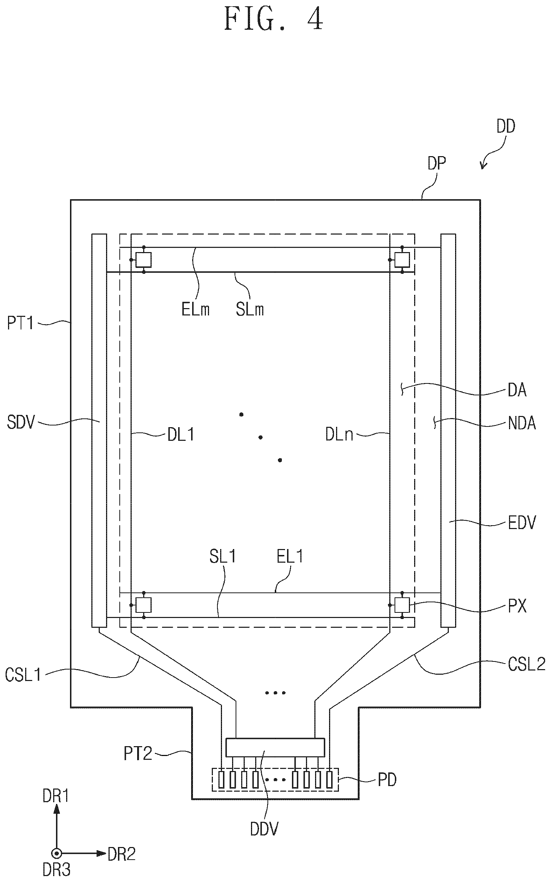

FIG. 4 is a plan view of the display panel illustrated in FIG. 2.

Referring to FIG. 4, the display device DD may include the display panel DP, a scan driver SDV, a data driver DDV, a light emission driver EDV, and a plurality of pads PD.

The display panel DP may include a first part PT1 and a second part PT2 extending from the first part PT1. The second part PT2 may have a smaller width in the second direction DR2 than the first part PT1. The first part PT1 may include a display region DA and a non-display region NDA surrounding the display region DA. The second part PT2 may be defined as the non-display region NDA.

The display panel DP may include a plurality of pixels PX, a plurality of scan lines SL1 to SLm, a plurality of data lines DL1 to DLn, a plurality of light emission lines EL1 to ELm, and first and second control lines CSL1 and CSL2. "m" and "n" are natural numbers.

Although not illustrated, the display panel DP may include a sensing unit for sensing a fingerprint. That is, the sensing unit for sensing a fingerprint may not be manufactured as a separate module and may be imbedded in the display panel. The sensing unit may include a plurality of sensors disposed between the pixels. The configuration of the sensors will be described below in detail.

The pixels PX may be disposed in the display region DA. The scan driver SDV and the light emission driver EDV may be disposed in the non-display regions NDA adjacent to opposite sides of the display panel DP that extend in the first direction DR1 and face away from each other in the second direction DR2.

The data driver DDV and the pads PD may be disposed on the second part PT2. The pads PD may be closer to one side of the second part PT2 than the data driver DDV. The one side of the second part PT2 may extend in the second direction DR2.

The scan lines SL1 to SLm may extend in the second direction DR2 and may be connected to the pixels PX and the scan driver SDV. The data lines DL1 to DLn may extend in the first direction DR1 and may be connected to the pixels PX and the data driver DDV. The light emission lines EL1 to ELm may extend in the second direction DR2 and may be connected to the pixels PX and the light emission driver EDV.

Although not illustrated, the display panel DP may include a first power line that receives a first voltage and a second power line that receives a second voltage having a lower level than the first voltage. The first and second power lines may extend to the display region DA and may be connected to the pixels PX.

The first control line CSL1 may be connected to the scan driver SDV and may extend toward the second part PT2. The second control line CSL2 may be connected to the light emission driver EDV and may extend toward the second part PT2. The data driver DDV may be disposed between the first control line CSL1 and the second control line CSL2.

The data driver DDV and the first and second control lines CSL1 and CSL2 may be connected to the pads PD. The data lines DL1 to DLn may be connected to the data driver DDV, and the data driver DDV may be connected to the pads PD corresponding to the data lines DL1 to DLn.

Although not illustrated, the display device DD may further include a timing controller for controlling operations of the scan driver SDV, the data driver DDV, and the light emission driver EDV. The timing controller may be mounted on a printed circuit board and may be connected to the pads PD through the printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The light emission driver EDV may generate a plurality of light emission signals, and the light emission signals may be applied to the pixels PX through the light emission lines EL1 to ELm.

The pixels PX may receive the data voltages in response to the scan signals. The pixels PX may display an image by emitting light having luminance corresponding to the data voltages in response to the light emission signals.

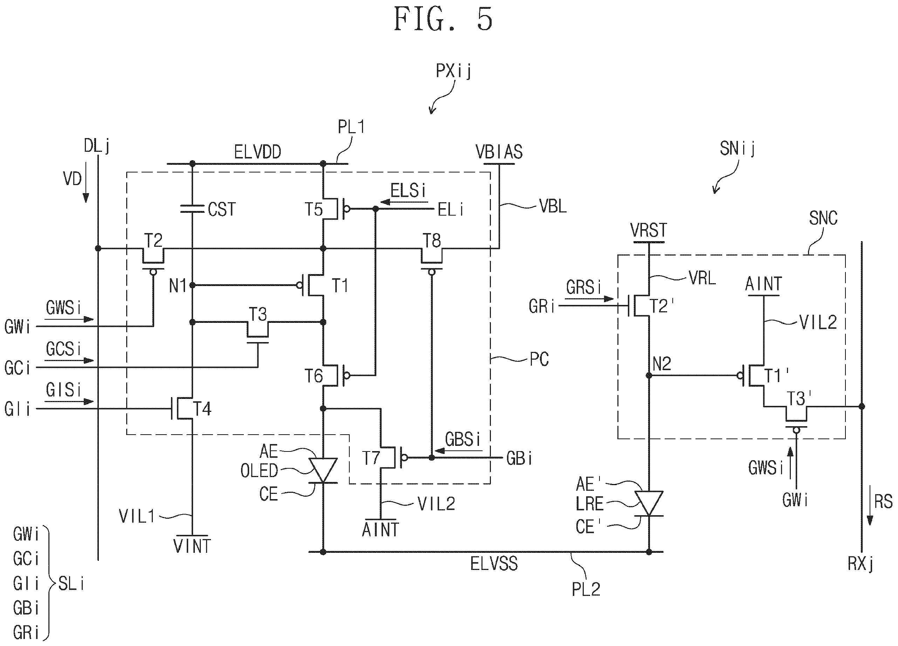

FIG. 5 illustrates an equivalent circuit diagram of one pixel among the pixels illustrated in FIG. 4 and a sensor adjacent to the pixel.

In FIG. 5, a pixel PXij connected to the i-th scan line SLi, the i-th light emission line ELi, and the j-th data line DLj is illustrated as an example. In addition, a sensor SNij connected to the i-th reset scan line GRi and the j-th receiving line RXj is illustrated in FIG. 5. "i" and "j" are natural numbers.

Referring to FIG. 5, the pixel PXij may include a pixel circuit PC and a light emitting element OLED connected to the pixel circuit PC. The pixel circuit PC may drive the light emitting element OLED.

The pixel circuit PC may include a plurality of transistors T1 to T8 and a capacitor CST. The transistors T1 to T8 and the capacitor CST may control the amount of current flowing through the light emitting element OLED. The light emitting element OLED may generate light having a predetermined luminance depending on the amount of current provided thereto.

The i-th scan line SLi may include the i-th write scan line GWi, the i-th compensation scan line GCi, the i-th initialization scan line GIi, the i-th bias scan line GBi, and the i-th reset scan line GRi.

The i-th write scan line GWi may receive the i-th write scan signal GWSi, and the i-th compensation scan line GCi may receive the i-th compensation scan signal GCSi. The i-th initialization scan line GIi may receive the i-th initialization scan signal GISi, and the i-th bias scan line GBi may receive the i-th bias scan signal GBSi. The i-th reset scan line GRi may receive the i-th reset scan signal GRSi. The i-th light emission line ELi may receive the i-th light emission signal ELSi.

The pixel PXij may be connected to the j-th data line DLj, the i-th write scan line GWi, the i-th compensation scan line GCi, the i-th initialization scan line GIi, the i-th bias scan line GBi, the i-th light emission line ELi, a first initialization line VIL1, a second initialization line VIL2, a bias line VBL, and first and second power lines PL1 and PL2.

The pixel circuit PC may be connected to the j-th data line DLj, the i-th write scan line GWi, the i-th compensation scan line GCi, the i-th initialization scan line GIi, the i-th bias scan line GBi, the i-th light emission line ELi, the first initialization line VIL1, the second initialization line VIL2, the bias line VBL, and the first power line PL1. The light emitting element OLED may be connected to the second power line PL2.

The first initialization line VIL1 may receive a first initialization voltage VINT, and the second initialization line VIL2 may receive a second initialization voltage AINT. The bias line VBL may receive a bias voltage VBIAS. The first power line PL1 may receive a first voltage ELVDD, and the second power line PL2 may receive a second voltage ELVSS.

Each of the transistors T1 to T8 may include a source electrode, a drain electrode, and a gate electrode. Hereinafter, in FIG. 5, for convenience, one of the source electrode and the drain electrode is defined as a first electrode, and the other is defined as a second electrode. In addition, the gate electrode is defined as a control electrode.

The transistors T1 to T8 may include the first to eighth transistors T1 to T8. The first, second, fifth, and eighth transistors T1, T2, T5, and T8 may be PMOS transistors. The third and fourth transistors T3 and T4 may be NMOS transistors.

The first transistor T1 may be defined as a drive transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light emission control transistors. The eighth transistor T8 may be defined as a bias transistor.

The light emitting element OLED may be defined as an organic light emitting element. The light emitting element OLED may include an anode AE and a cathode CE. The anode AE may receive the first voltage ELVDD through the sixth, first, and fifth transistors T6, T1, and T5. The first voltage ELVDD may be applied to the pixel circuit PC through the first power line PL1. The cathode CE may receive the second voltage ELVSS having a lower level than the first voltage ELVDD. The second voltage ELVSS may be applied to the pixel circuit PC through the second power line PL2.

The first transistor T1 may be disposed between the fifth transistor T5 and the sixth transistor T6 and may be connected to the fifth transistor T5 and the sixth transistor T6. The first transistor T1 may be connected to the first power line PL1 through the fifth transistor T5 and may be connected to the anode AE through the sixth transistor T6.

The first transistor T1 may include a first electrode connected to the first power line PL1 through the fifth transistor T5, a second electrode connected to the anode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the light emitting element OLED depending on the voltage of the first node N1 applied to the control electrode of the first transistor T1.

The second transistor T2 may be disposed between the first transistor T1 and the j-th data line DLj and may be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWi.

The second transistor T2 may be turned on by the i-th write scan signal GWSi applied through the i-th write scan line GWi and may electrically connect the j-th data line DLj and the first electrode of the first transistor T1. The second transistor T2 may perform a switching operation of providing a data voltage VD applied through the j-th data line DLj to the first electrode of the first transistor T1.

The third transistor T3 may be connected to the second electrode of the first transistor T1 and the first node N1. The third transistor T3 may include a first electrode connected to the second electrode of the first transistor T1, a second electrode connected to the first node N1, and a control electrode connected to the i-th compensation scan line GCi.

The third transistor T3 may be turned on by the i-th compensation scan signal GCSi applied through the i-th compensation scan line GCi and may electrically connect the second electrode of the first transistor T1 and the control electrode of the first transistor T1. When the third transistor T3 is turned on, the first transistor T1 and the third transistor T3 may be connected in a diode form.

The fourth transistor T4 may be connected to the first node N1. The fourth transistor T4 may include a first electrode connected to the first node N1, a second electrode connected to the first initialization line VIL1, and a control electrode connected to the i-th initialization scan line GIi. The fourth transistor T4 may be turned on by the i-th initialization scan signal GISi applied through the i-th initialization scan line GIi and may provide the first initialization voltage VINT applied through the first initialization line VIL1 to the first node N1.

The fifth transistor T5 may include a first electrode connected to the first power line PL1, a second electrode connected to the first electrode of the first transistor T1, and a control electrode connected to the i-th light emission line ELi.

The sixth transistor T6 may include a first electrode connected to the second electrode of the first transistor T1, a second electrode connected to the anode AE, and a control electrode connected to the i-th light emission line ELi.

The fifth transistor T5 and the sixth transistor T6 may be turned on by the i-th light emission signal ESi applied through the i-th light emission line ELi. The first voltage ELVDD may be provided to the light emitting element OLED by the turned-on fifth transistor T5 and the turned-on six transistor T6, and a drive current may flow through the light emitting element OLED. Accordingly, the light emitting element OLED may emit light.

The seventh transistor T7 may include a first electrode connected to the anode AE, a second electrode connected to the second initialization line VIL2, and a control electrode connected to the i-th bias scan line GBi. The seventh transistor T7 may be turned on by the i-th bias scan signal GBSi applied through the i-th bias scan line GBi and may provide the second initialization voltage AINT applied through the second initialization line VIL2 to the anode AE of the light emitting element OLED.

In an embodiment of the present disclosure, the seventh transistor T7 may be omitted. In an embodiment of the present disclosure, the second initialization voltage AINT may have a level different from that of the first initialization voltage VINT. However, without being limited thereto, the second initialization voltage AINT may have the same level as the first initialization voltage VINT.

The seventh transistor T7 may improve the ability of the pixel PXij to express black. When the seventh transistor T7 is turned on, a parasitic capacitor (not illustrated) of the light emitting element OLED may be discharged. Accordingly, when black luminance is implemented, the light emitting element OLED does not emit light due to the leakage current of the first transistor T1, and thus the ability to express black may be improved.

The capacitor CST may include a first electrode connected to the first power line PL1 and a second electrode connected to the first node N1. When the fifth transistor T5 and the sixth transistor T6 are turned on, the amount of current flowing through the first transistor T1 may be determined depending on the voltage stored in the capacitor CST.

The eighth transistor T8 may include a first electrode connected to the bias line VBL, a second electrode connected to the first electrode of the first transistor T1, and a control electrode connected to the i-th bias scan line GBi. In an embodiment of the present disclosure, the eighth transistor T8 may be omitted.

The eighth transistor T8 may be turned on by the i-th bias scan signal GBSi and may provide the bias voltage VBIAS to the first electrode of the first transistor T1. When the bias voltage VBIAS is applied to the first transistor T1, movement of the hysteresis curve of the first transistor T1 may be suppressed.

The sensor SNij may include a sensing circuit SNC and a light receiving element LRE connected to the sensing circuit SNC. The sensing circuit SNC may drive the light receiving element LRE.

The sensing circuit SNC may include a first transistor T1', a second transistor T2', and a third transistor T3'. The first and third transistors T1' and T3' may be PMOS transistors, and the second transistor T2' may be an NMOS transistor.

The light receiving element LRE may be defined as a photo diode. The light receiving element LRE may convert light energy incident from the outside into electrical energy. The light receiving element LRE may include an anode AE' and a cathode CE'. The anode AE' may be connected to a second node N2, and the cathode CE' may be connected to the second power line PL2.

The first transistor T1' may be connected to the light receiving element LRE, the second transistor T2', and the third transistor T3'. The first transistor T1' may include a first electrode that receives the second initialization voltage AINT, a control electrode connected to the second node N2, and a second electrode connected to the third transistor T3'. The first electrode of the first transistor T1' may be connected to the second initialization line VIL2 to receive the second initialization voltage AINT.

The second transistor T2' may include a first electrode connected to the second node N2, a control electrode connected to the i-th reset scan line GRi, and a second electrode connected to a reset line VRL that receives a reset voltage VRST.

The third transistor T3' may include a first electrode connected to the second electrode of the first transistor T1', a control electrode connected to the i-th write scan line GWi, and a second electrode connected to the receiving line RXj. The third transistor T3' may be turned on by the i-th write scan signal GWSi received through the i-th write scan line GWi.

The second transistor T2' may be turned on by the i-th reset scan signal GRSi received through the i-th reset scan line GRi. The turned-on second transistor T2' may receive the reset voltage VRST and may provide the reset voltage VRST to the second node N2. The second node N2 may be reset by the reset voltage VRST.

The i-th write scan signal GWSi may be applied to the control electrode of the third transistor T3', and the third transistor T3' may be turned on accordingly. The first transistor T1' may be connected to the receiving line RXj by the turned-on third transistor T3'.

The light receiving element LRE may receive light and may convert the light into an electrical signal. At this time, the voltage of the second node N2 may change. When the first transistor T1' is turned on, the second initialization voltage AINT provided to the first transistor T1' may be controlled depending on the change in the voltage of the second node N2 and may be provided to the receiving line RXj through the third transistor T3'. Accordingly, a signal sensed by the light receiving element LRE may be output through the receiving line RXj as a sensing signal RS.

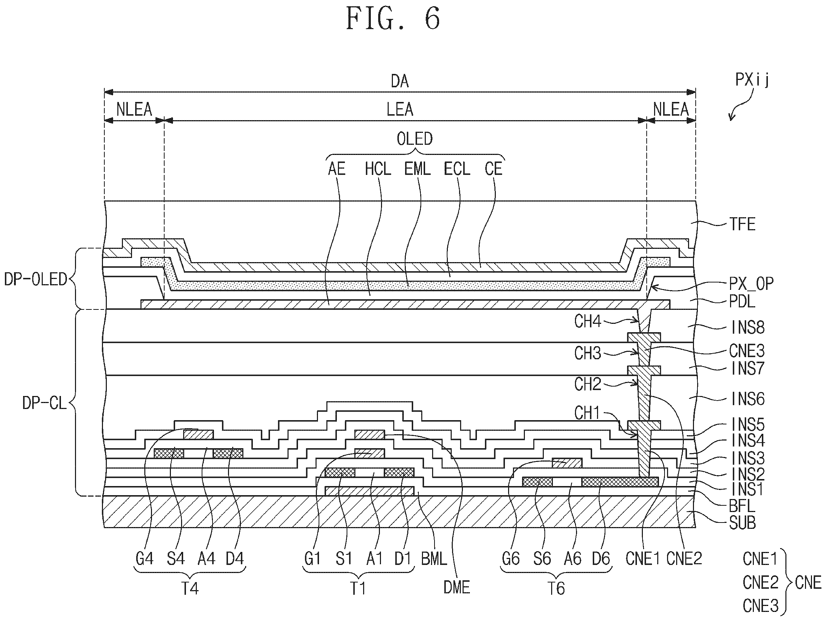

FIG. 6 is a sectional view illustrating the light emitting element, the first transistor, the fourth transistor, and the sixth transistor of the pixel illustrated in FIG. 5.

Referring to FIG. 6, the light emitting element OLED may include a first electrode AE, a second electrode CE, a hole control layer HCL, an electron control layer ECL, and an emissive layer EML. The first electrode AE may be the anode AE illustrated in FIG. 5, and the second electrode CE may be the cathode CE illustrated in FIG. 5. The second electrode CE may be disposed over the first electrode AE, and the hole control layer HCL, the electron control layer ECL, and the emissive layer EML may be disposed between the first electrode AE and the second electrode CE.

The first, fourth, and sixth transistors T1, T4, and T6 and the light emitting element OLED may be disposed on the substrate SUB. The display region DA may include an emissive region LEA corresponding to the pixel PXij and a non-emissive region NLEA adjacent to the emissive region LEA. The light emitting element OLED may be disposed in the emissive region LEA.

A lower metal layer BML may be disposed on the substrate SUB. The lower metal layer BML may overlap the first transistor T1. Although not illustrated, a constant voltage may be applied to the lower metal layer BML. When the constant voltage is applied to the lower metal layer BML, the threshold voltage Vth of the first transistor T1 disposed over the lower metal layer BML may remain unchanged.

Furthermore, the lower metal layer BML may block light incident to the first transistor T1 from below the lower metal layer BML. For example, the lower metal layer BML may include reflective metal. The lower metal layer BML may be omitted.

A buffer layer BFL may be disposed on the substrate SUB. The buffer layer BFL may be an inorganic layer. The buffer layer BFL may cover the lower metal layer BML. A semiconductor layer S1, A1, and D1 of the first transistor T1 and a semiconductor layer S6, A6, and D6 of the sixth transistor T6 may be disposed on the buffer layer BFL. The semiconductor layers S1, A1, D1, S6, A6, and D6 may include poly silicon. However, without being limited thereto, the semiconductor layers S1, A1, D1, S6, A6, and D6 may include amorphous silicon.

The semiconductor layers S1, A1, D1, S6, A6, and D6 may be doped with an N-type dopant or a P-type dopant. The semiconductor layers S1, A1, D1, S6, A6, and D6 may include heavily doped regions and lightly doped regions. The heavily doped regions may have a higher conductivity than the lightly doped regions and may substantially serve as source electrodes and drain electrodes of the first and sixth transistors T1 and T6. The lightly doped regions may substantially correspond to active (or, channel) regions of the first and sixth transistors T1 and T6.

The first source region S1, the first channel region A1, and the first drain region D1 of the first transistor T1 may be formed from the semiconductor layer S1, A1, and D1. The sixth source region S6, the sixth channel region A6, and the sixth drain region D6 of the sixth transistor T6 may be formed from the semiconductor layer S6, A6, and D6. The first channel region A1 may be disposed between the first source region S1 and the first drain region D1. The sixth channel region A6 may be disposed between the sixth source region S6 and the sixth drain region D6.

A first insulating layer INS1 may be disposed on the buffer layer BFL to cover the semiconductor layers S1, A1, D1, S6, A6, and D6. The first and sixth gate electrodes G1 and G6 (or, the control electrodes) of the first and sixth transistors T1 and T6 may be disposed on the first insulating layer INS1.

Although not explicitly illustrated, a structure of a source region, a channel region, a drain region, and a gate electrode of each of the second, fifth, seventh, and eighth transistors T2, T5, T7, and T8 may be substantially the same as those of the first and sixth transistors T1 and T6.

A second insulating layer INS2 may be disposed on the first insulating layer INS1 to cover the first and sixth gate electrodes G1 and G6. A dummy electrode DME may be disposed on the second insulating layer INS2. The dummy electrode DME may be disposed above the first gate electrode G1 and may overlap the first gate electrode G1 when viewed from the DR1-DR2 plane. The dummy electrode DME may form the above-described capacitor CST together with the first gate electrode G1.

A third insulating layer INS3 may be disposed on the second insulating layer INS2 to cover the dummy electrode DME. A semiconductor layer S4, A4, and D4 of the fourth transistor T4 may be disposed on the third insulating layer INS3. The semiconductor layer S4, A4, and D4 may include an oxide semiconductor formed of metal oxide. The oxide semiconductor may include a crystalline or amorphous oxide semiconductor.

The semiconductor layer S4, A4, and D4 may include a plurality of regions distinguished from one other depending on whether metal oxide is reduced or not. A region where metal oxide is reduced (hereinafter, referred to as the reduced region) has a higher conductivity than a region where metal oxide is not reduced (hereinafter, referred to as the non-reduced region). The reduced region may substantially serve as a source electrode or a drain electrode of the fourth transistor T4. The non-reduced region may substantially correspond to an active (or, channel) region of the fourth transistor T4.

The fourth source region S4, the fourth channel region A4, and the fourth drain region D4 of the fourth transistor T4 may be formed from the semiconductor layer S4, A4, and D4. The fourth channel region A4 may be disposed between the fourth source region S4 and the fourth drain region D4.

A fourth insulating layer INS4 may be disposed on the third insulating layer INS3 to cover the semiconductor layer S4, A4, and D4. The fourth gate electrode G4 of the fourth transistor T4 may be disposed on the fourth insulating layer INS4.

A fifth insulating layer INS5 may be disposed on the fourth insulating layer INS4 to cover the fourth gate electrode G4. The buffer layer BFL and the first to fifth insulating layers INS1 to INS5 may include inorganic layers. Although not illustrated, a structure of a source region, a channel region, a drain region, and a gate electrode of the third transistor T3 may be substantially the same as that of the fourth transistor T4.

A connecting electrode CNE may be disposed between the sixth transistor T6 and the light emitting element OLED. The connecting electrode CNE may electrically connect the sixth transistor T6 and the light emitting element OLED. The connecting electrode CNE may include a first connecting electrode CNE1, a second connecting electrode CNE2 disposed on the first connecting electrode CNE1, and a third connecting electrode CNE3 disposed on the second connecting electrode CNE2.

The first sub-connecting electrode CNE1 may be disposed on the fifth insulating layer INS5 and may be connected to the sixth drain region D6 through a first contact hole CH1 defined in the first to fifth insulating layers INS1 to INS5. A sixth insulating layer INS6 may be disposed on the fifth insulating layer INS5 to cover the first connecting electrode CNE1.

The second connecting electrode CNE2 may be disposed on the sixth insulating layer INS6. The second connecting electrode CNE2 may be connected to the first connecting electrode CNE1 through a second contact hole CH2 defined in the sixth insulating layer INS6. A seventh insulating layer INS7 may be disposed on the sixth insulating layer INS6 to cover the second connecting electrode CNE2.

The third connecting electrode CNE3 may be disposed on the seventh insulating layer INS7. The third connecting electrode CNE3 may be connected to the second connecting electrode CNE2 through a third contact hole CH3 defined in the seventh insulating layer INS7. An eighth insulating layer INS8 may be disposed on the seventh insulating layer INS7 to cover the third connecting electrode CNE3. The sixth to eighth insulating layers INS6 to INS8 may include an inorganic layer or an organic layer.

The first electrode AE may be disposed on the eighth insulating layer INS8. The first electrode AE may be electrically connected to the third connecting electrode CNE3 through a fourth contact hole CH4 defined in the eighth insulating layer INS8.

A pixel defining layer PDL exposing a predetermined portion of the first electrode AE may be disposed on the first electrode AE and the eighth insulating layer INS8. An opening PX-OP for exposing the predetermined portion of the first electrode AE may be defined in the pixel defining layer PDL.

The hole control layer HCL may be disposed on the first electrode AE and the pixel defining layer PDL. The hole control layer HCL may be commonly disposed in the emissive region LEA and the non-emissive region NLEA. The hole control layer HCL may include a hole transport layer and a hole injection layer.

The emissive layer EML may be disposed on the hole control layer HCL. The emissive layer EML may be disposed in a region corresponding to the opening PX_OP. The emissive layer EML may include an organic material and/or an inorganic material. The emissive layer EML may generate one of red light, green light, and blue light.

The electron control layer ECL may be disposed on the emissive layer EML and the hole control layer HCL. The electron control layer ECL may be commonly disposed in the emissive region LEA and the non-emissive region NLEA. The electron control layer ECL may include an electron transport layer and an electron injection layer.

The second electrode CE may be disposed on the electron control layer ECL. The second electrode CE may be commonly disposed in the pixels PX. That is, the second electrode CE may be commonly disposed over the emissive layers EML of the pixels PX.

The layers from the buffer layer BFL to the eighth insulating layer INS8 may be defined as the circuit element layer DP-CL. The layer in which the light emitting element OLED is disposed may be defined as the display element layer DP-OLED.

The thin film encapsulation layer TFE may be disposed on the light emitting element OLED. The thin film encapsulation layer TFE may include an inorganic layer, an organic layer, and an in organic layer that are sequentially stacked one above another. The inorganic layers may include an inorganic material and may protect the pixels PX from moisture/oxygen. The organic layer may include an organic material and may protect the pixels PX from foreign matter such as dust particles.

The first voltage ELVDD may be applied to the first electrode AE, and the second voltage EVLSS may be applied to the second electrode CE. Holes and electrons injected into the emissive layer EML may be combined to form excitons, and the light emitting element OLED may emit light as the excitons transition to a ground state. An image may be displayed as the light emitting element OLED emits the light.

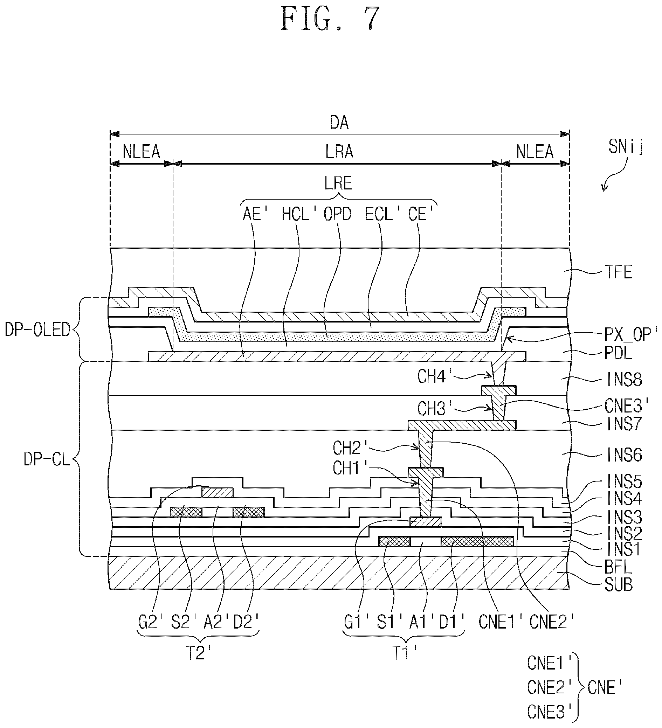

FIG. 7 is a sectional view illustrating the light receiving element, the first transistor, and the second transistor of the sensor illustrated in FIG. 5.

The following description of the configuration illustrated in FIG. 7 will focus on structural differences from the stacked structure illustrated in FIG. 6.

Referring to FIG. 7, the display region DA may include a light receiving region LRA corresponding to the sensor SNij and a non-emissive region NLEA adjacent to the light receiving region LRA. The non-emissive region NLEA may be the non-emissive region NLEA illustrated in FIG. 6.

The light receiving element LRE may include a first electrode AE', a second electrode CE', a hole control layer HCL', an electron control layer ECL', and a light receiving layer OPD. The first electrode AE' may be the anode AE' illustrated in FIG. 5, and the second electrode CE' may be the cathode CE' illustrated in FIG. 5.

The light receiving layer OPD may be defined as an organic photo diode. The first electrode AE', the second electrode CE', the hole control layer HCL', and the electron control layer ECL' may be substantially the same components as the first electrode AE, the second electrode CE, the hole control layer HCL, and the electron control layer ECL illustrated in FIG. 6.

The position in which the light receiving layer OPD is disposed in FIG. 7 may correspond to the position in which the emissive layer EML is disposed in FIG. 6. That is, the second electrode CE' may be disposed over the first electrode AE', and the hole control layer HCL', the electron control layer ECL', and the light receiving layer OPD may be disposed between the first electrode AE' and the second electrode CE'. The second electrode CE' may be commonly disposed over the light receiving layers OPD of the light receiving elements LRE. The second electrode CE' may be integrally formed with the second electrode CE illustrated in FIG. 6.

The first transistor T1' may include a first source region S1', a first drain region D1', a first channel region A1', and a first gate electrode G1'. The second transistor T2' may include a second source region S2', a second drain region D2', a second channel region A2', and a second gate electrode G2'.

A stacked structure of the first transistor T1' may be substantially the same as the stacked structure of the first transistor T1 illustrated in FIG. 6. A stacked structure of the second transistor T2' may be substantially the same as the stacked structure of the fourth transistor T4 illustrated in FIG. 6. Although not explicitly illustrated, a stacked structure of the third transistor T3' may be substantially the same as the stacked structure of the first transistor T1'.

A connecting electrode CNE' may include a first connecting electrode CNE1', a second connecting electrode CNE2', and a third connecting electrode CNE3' . The first connecting electrode CNE1' may be disposed in the same layer as the first connecting electrode CNE1 illustrated in FIG. 6, the second connecting electrode CNE2' may be disposed in the same layer as the second connecting electrode CNE2 illustrated in FIG. 6, and the third connecting electrode CNE3' may be disposed in the same layer as the third connecting electrode CNE3 illustrated in FIG. 6.

The first connecting electrode CNE1' may be connected to the first gate electrode G1' of the first transistor T1' through a first contact hole CH1' defined in the second to fifth insulating layers INS2 to INS5. The second connecting electrode CNE2' may be connected to the first connecting electrode CNE1' through a second contact hole CH2' defined in the sixth insulating layer INS6. The third connecting electrode CNE3' may be connected to the second connecting electrode CNE2' through a third contact hole CH3' defined in the seventh insulating layer INS7. The first electrode AE' may be connected to the third connecting electrode CNE3' through a fourth contact hole CH4' defined in the eighth insulating layer INS8.

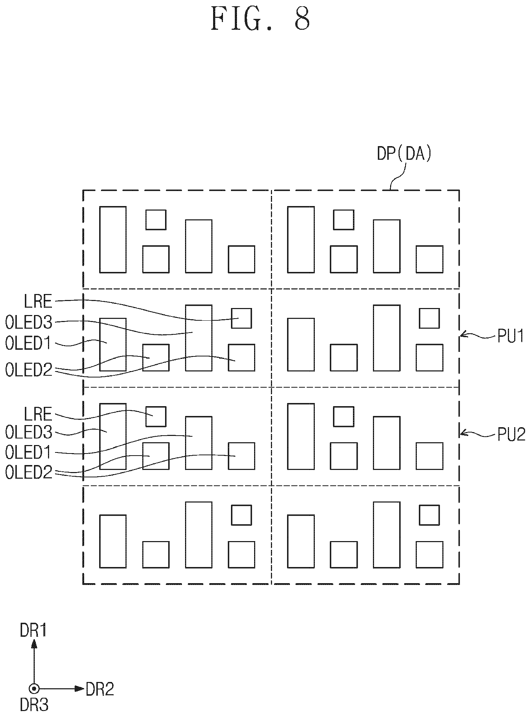

FIG. 8 is a view illustrating a planar arrangement state of light emitting elements and light receiving elements disposed in a partial area of the display region illustrated in FIG. 4.

Referring to FIG. 8, each of first, second, and third light emitting elements OLED1, OLED2, and OLED3 may correspond to the light emitting element OLED illustrated in FIGS. 5 and 6. Each of light receiving elements LRE may correspond to the light receiving element LRE illustrated in FIGS. 5 and 7. The first light emitting elements OLED1 may display red. The second light emitting elements OLED2 may display green. The third light emitting elements OLED3 may display blue.

The display panel DP may include a plurality of first pixel units PU1 and a plurality of second pixel units PU2. The first pixel units PU1 may be arranged in the second direction DR2. The second pixel units PU2 may be adjacent to the first pixel units PU1 in the first direction DR1 and may be arranged in the second direction DR2.

Each of the first pixel units PU1 may include one first light emitting element OLED1, two second light emitting elements OLED2, one third light emitting element OLED3, and one light emitting element LRE. In each of the first pixel units PU1, the first, second, and third light emitting elements OLED1, OLED2, and OLED3 may be arranged in the second direction DR2 in the order of the first light emitting element OLED1, the second light emitting element OLED2, the third light emitting element OLED3, and the second light emitting element OLED2.

In each of the first pixel units PU1, the light receiving element LRE may be adjacent to the third light emitting element OLED3 and the second light emitting element OLED2 that is second from the left. In each of the first pixel units PU1, the light receiving element LRE may be adjacent in the first direction DR1 to the second light emitting element OLED2 that is second from the left.

Each of the second pixel units PU2 may include one first light emitting element OLED1, two second light emitting elements OLED2, one third light emitting element OLED3, and one light emitting element LRE. In each of the second pixel units PU2, the first, second, and third light emitting elements OLED1, OLED2, and OLED3 may be arranged in the second direction DR2 in the order of the third light emitting element OLED3, the second light emitting element OLED2, the first light emitting element OLED1, and the second light emitting element OLED2.

In each of the second pixel units PU2, the light receiving element LRE may be adjacent to the third light emitting element OLED3 and the second light emitting element OLED2 that is first from the left. In each of the second pixel units PU2, the light receiving element LRE may be adjacent in the first direction DR1 to the second light emitting element OLED2 that is first from the left.

In each of the first and second pixel units PU1 and PU2, when viewed from above the plane, the first light emitting element OLED1 may have a larger area than the second light emitting elements OLED2, and the third light emitting element OLED3 may have a larger area than the first light emitting element OLED1. Furthermore, in each of the first and second pixel units PU1 and PU2, when viewed from above the plane, the second light emitting elements OLED2 may have a larger area than the light receiving element LRE.

The first, second, and third light emitting elements OLED1, OLED2, and OLED3 and the light receiving elements LRE may have a quadrangular shape when viewed from above the plane. However, without being limited thereto, the first, second, and third light emitting elements OLED1, OLED2, and OLED3 and the light receiving elements LRE may have various shapes such as a rhombic shape, a circular shape, and the like.

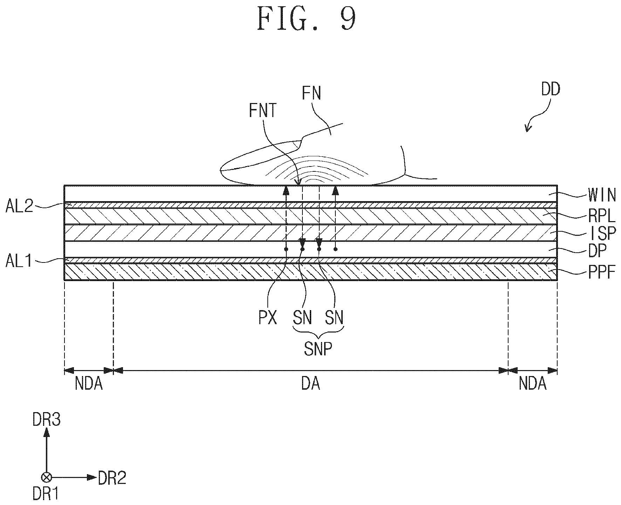

FIG. 9 is a view illustrating a fingerprint sensing state by sensors illustrated in FIGS. 5 and 7.

Referring to FIG. 9, the display device DD may include a sensing unit SNP imbedded in the display panel DP, and the sensing unit SNP may include a plurality of sensors SN. Each of the sensors SN may have the same configuration as the sensor SNij illustrated in FIGS. 5 and 7. For example, two sensors SN are illustrated in FIG. 9. However, more sensors SN may be disposed in the display panel DP and may constitute the sensing unit SNP.

The sensors SN may sense a fingerprint FNT of a finger FN on the display panel DP. Light generated from the light emitting elements OLED of the pixels PX may be provided to the fingerprint FNT and may be reflected from the fingerprint FNT.

The light reflected from the fingerprint FNT may be sensed by light receiving elements LRE of the sensors SN. The sensors SN may sense the fingerprint FNT through the light reflected from the fingerprint FNT. A control module (not illustrated) of the display device DD may receive fingerprint information sensed by the sensors SN and may perform a user authentication mode using the received fingerprint information.

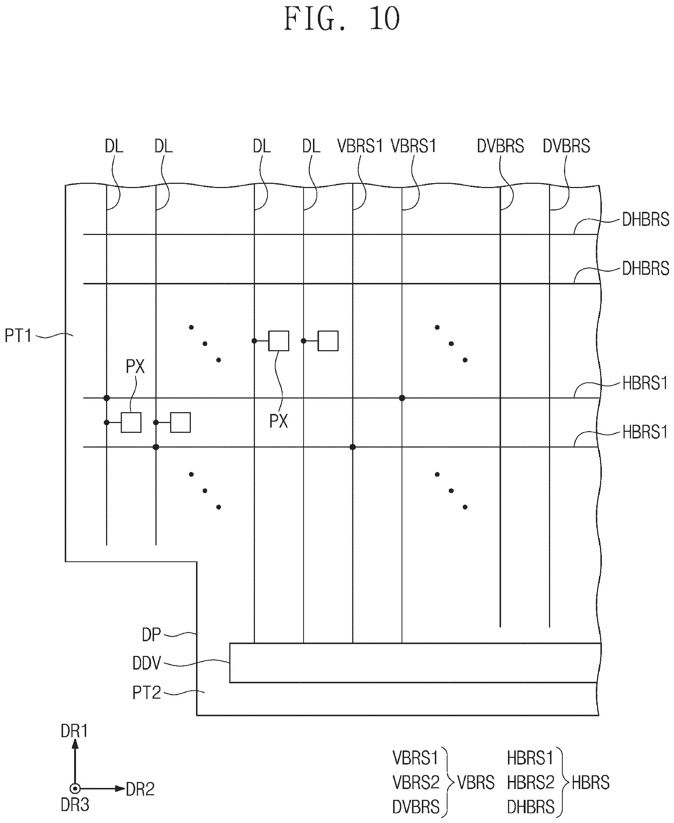

FIG. 10 is a plan view illustrating a connection state of data lines and vertical and horizontal lines for the border of the display panel illustrated in FIG. 4.

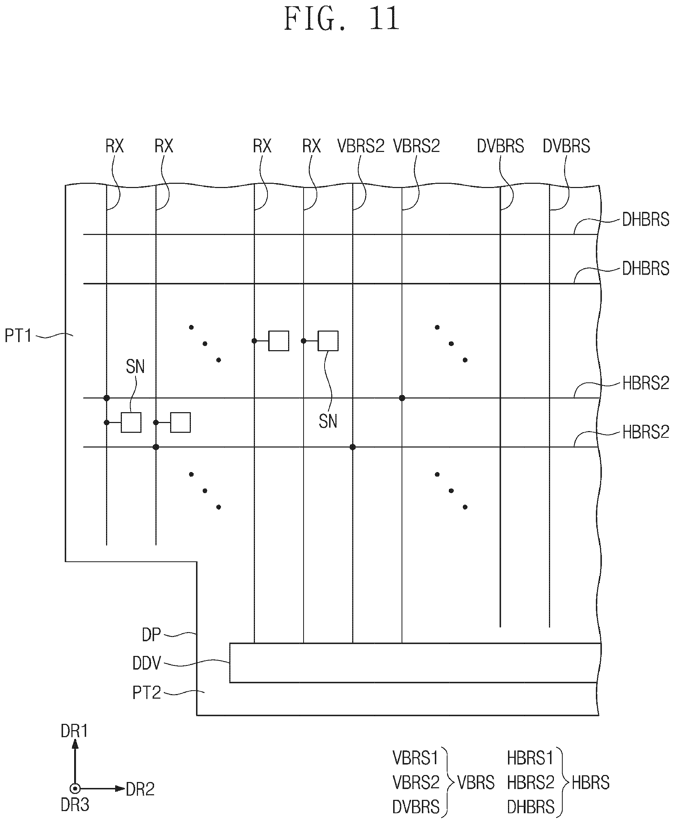

FIG. 11 is a plan view illustrating a connection state of receiving lines and vertical and horizontal lines for the border of the display panel illustrated in FIG. 4.

For example, only some data lines DL, some receiving lines RX, some vertical lines VBRS, and some horizontal lines HBRS required for description are illustrated in FIGS. 10 and 11, and the remaining lines are omitted. Furthermore, the order of the lines is not illustrated with separate symbols.

Referring to FIGS. 10 and 11, the display panel DP may include a plurality of vertical lines VBRS and a plurality of horizontal lines HBRS. The vertical lines VBRS may include first vertical lines VBRS1, second vertical lines VBRS2, and dummy vertical lines DVBRS. The horizontal lines HBRS may include first horizontal lines HBRS1, second horizontal lines HBRS2, and dummy horizontal lines DHBRS.

The first vertical lines VBRS1 may be defined as first-first lines, and the first horizontal lines HBRS1 may be defined as first-second lines. The second vertical lines VBRS2 may be defined as second-first lines, and the second horizontal lines HBRS2 may be defined as second-second lines.

Referring to FIG. 10, the first vertical lines VBRS1 and the dummy vertical lines DVBRS may extend in the first direction DR1 and may be arranged in the second direction DR2. The first horizontal lines HBRS 1 and the dummy horizontal lines DHBRS may extend in the second direction DR2 and may be arranged in the first direction DR1.

When viewed from above the plane, the first vertical lines VBRS1, the dummy vertical lines DVBRS, and the data lines DL may extend to cross the first horizontal lines HBRS1 and the dummy horizontal lines DHBRS.

Based on the second direction DR2, the width of the second part PT2 having the data driver DDV disposed thereon may be less than the width of the first part PT1 having the pixels PX disposed thereon. In this case, it may be difficult to directly connect some data lines DL extending in the first direction DR1 and adjacent to the border of the first part PT1 to the data driver DDV.

The data lines DL adjacent to the border of the first part PT1 may be connected to the data driver DDV through some of the vertical lines VBRS and some of the horizontal lines HBRS.

Specifically, the first vertical lines VBRS1 may be connected to the data driver DDV, and the first horizontal lines HBRS1 may be connected to the first vertical lines VBRS1, respectively. In addition, the first horizontal lines HBRS1 may be connected to the data lines DL adjacent to the border of the first part PT1. The data lines DL adj acent to the border of the first part PT1 may be connected to the data driver DDV through the first horizontal lines HBRS1 and the first vertical lines VBRS 1.

The vertical lines VBRS and the horizontal lines HBRS not being used to connect the data lines DL to the data driver DDV may be defined as the dummy vertical lines DVBRS and the dummy horizontal lines DHBRS. The dummy vertical lines DVBRS may not be connected to the data driver DDV. The dummy horizontal lines DHBRS may not be connected to the data lines DL and the first vertical lines VBRS1.

Referring to FIG. 11, the second vertical lines VBRS2 and the dummy vertical lines DVBRS may extend in the first direction DR1 and may be arranged in the second direction DR2. The second horizontal lines HBRS2 and the dummy horizontal lines DHBRS may extend in the second direction DR2 and may be arranged in the first direction DR1. The receiving lines RX may extend in the first direction DR1 and may be arranged in the second direction DR2.

When viewed from above the plane, the second vertical lines VBRS2, the dummy vertical lines DVBRS, and the receiving lines RX may extend to cross the second horizontal lines HBRS2 and the dummy horizontal lines DHBRS.

The receiving lines RX may be connected to the data driver DDV, and the above-described sensing signal RS may be output through the data driver DDV. For a reason similar to that of the data lines DL, it may be difficult to directly connect some receiving lines RX extending in the first direction DR1 and adjacent to the border of the first part PT1 to the data driver DDV.

Likewise to the data lines DL, the receiving lines RX adjacent to the border of the first part PT1 may be connected to the data driver DDV through some of the vertical lines VBRS and some of the horizontal lines HBRS.

Specifically, the second vertical lines VBRS2 may be connected to the data driver DDV, and the second horizontal lines HBRS2 may be connected to the second vertical lines VBRS2, respectively. The second horizontal lines HBRS2 may be connected to the receiving lines RX adjacent to the border of the first part PT1. The receiving lines RX adjacent to the border of the first part PT1 may be connected to the data driver DDV through the second horizontal lines HBRS2 and the second vertical lines VBRS2.

The vertical lines VBRS and the horizontal lines HBRS not being used to connect the receiving lines RX to the data driver DDV may be defined as the dummy vertical lines DVBRS and the dummy horizontal lines DHBRS. The dummy horizontal lines DHBRS may not be connected to the receiving lines RX and the second vertical lines VBRS2.

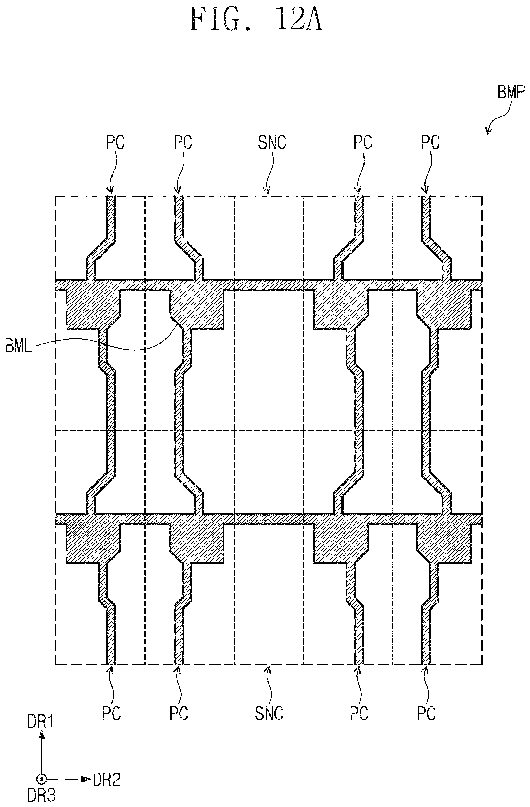

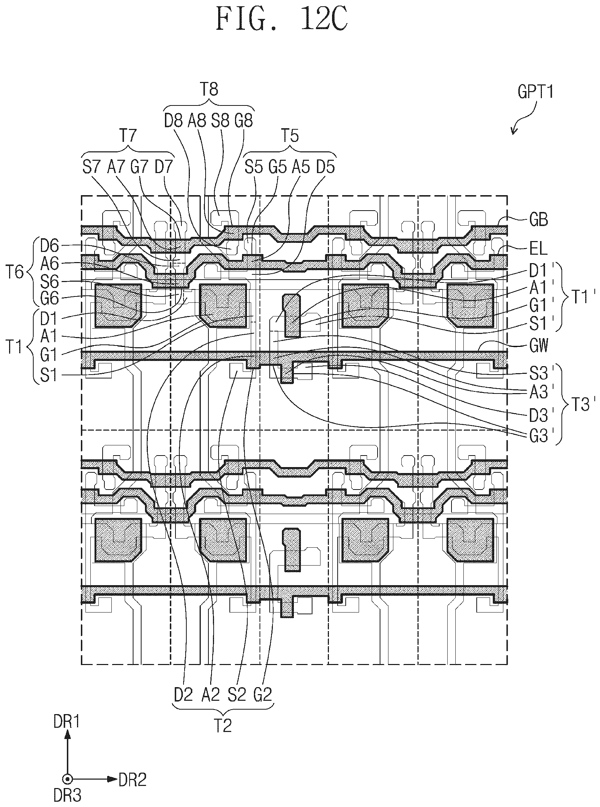

FIGS. 12A to 12I are views illustrating planar structures of pixel circuits and sensor circuits step by step.

FIGS. 12A to 12I are views illustrating a configuration in which the data lines DL, the first vertical data lines VBRS1, and the first horizontal data lines HBRS1 illustrated in FIG. 10 are connected with one another in the pixel circuits PC and the sensor circuits SNC. Each of the pixel circuits PC may correspond to the pixel circuit PC illustrated in FIG. 5, and each of the sensor circuits SNC may correspond to the sensor circuit SNC illustrated in FIG. 5.

For example, FIGS. 12A to 12I illustrate circuits connected to the light emitting elements OLED1, OLED2, and OLED3 and the light receiving element LRE of the first and second pixel units PU1 and PU2 adjacent to each other in the first direction DR1, which are illustrated in FIG. 8.

The pixel circuits PC and the sensor circuit SNC disposed above in the first direction DR1 may be circuits connected to the light emitting elements OLED1, OLED2, and OLED3 and the light receiving element LRE of the first pixel unit PU1 illustrated in FIG. 8. The pixel circuits PC and the sensor circuit SNC disposed below in the first direction DR1 may be circuits connected to the light emitting elements OLED1, OLED2, and OLED3 and the light receiving element LRE of the second pixel unit PU2 illustrated in FIG. 8.

In FIGS. 12A to 12I, the boundaries between the pixel circuits PC and the sensor circuits SNC are illustrated with dotted lines, and for convenience of description, the reference numerals of the pixel circuits PC and the sensor circuits SNC are illustrated only in FIG. 12A. Furthermore, a configuration of one pixel circuit PC among the pixel circuits PC, a configuration of one sensor circuit SNC among the sensor circuits SNC, and a configuration for lines connected to the pixel circuit PC and the sensor circuit SNC will be described with reference to FIGS. 12A to 12I.

FIGS. 12A to 12I depict the layouts of the pixel circuits PC and the sensor circuits SNC. In the descriptions of FIGS. 12A to 12I, the term "overlap" indicates a state in which components cover each other when viewed on a plane.

Referring to FIG. 12A, a lower conductive pattern BMP may be disposed on the substrate SUB illustrated in FIGS. 6 and 7. The lower metal layer BML illustrated in FIG. 12A may be formed by the lower conductive pattern BMP. The lower conductive pattern BMP may have various shapes without being limited to the shape illustrated in FIG. 12A. The lower metal layer BML illustrated in FIG. 6 may be formed by the lower conductive pattern BMP.

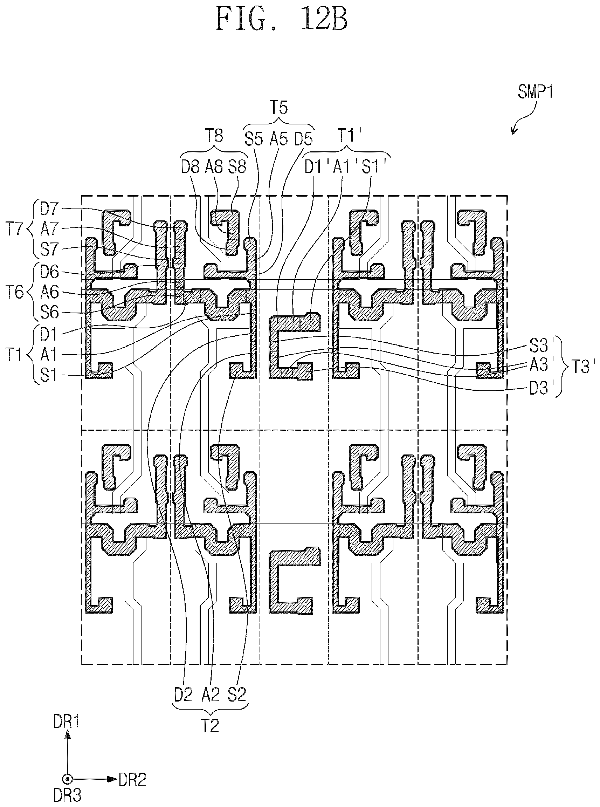

Referring to FIGS. 12A and 12B, a first semiconductor pattern SMP1 may be disposed on the lower conductive pattern BMP. The first semiconductor pattern SMP1 may have various shapes without being limited to the shape illustrated in FIG. 12B.

The first, second, fifth, sixth, seventh, and eighth source regions S1, S2, S5, S6, S7, and S8, the first, second, fifth, sixth, seventh, and eighth drain regions D1, D2, D5, D6, D7, and D8, and the first, second, fifth, sixth, seventh, and eighth channel regions A1, A2, A5, A6, A7, and A8 of the first, second, fifth, sixth, seventh, and eighth transistors T1, T2, T5, T6, T7, and T8 may be formed by the first semiconductor pattern SMP1.

The first, second, fifth, sixth, seventh, and eighth channel regions A1, A2, A5, A6, A7, and A8 may be disposed between the first, second, fifth, sixth, seventh, and eighth source regions S1, S2, S5, S6, S7, and S8 and the first, second, fifth, sixth, seventh, and eighth drain regions D1, D2, D5, D6, D7, and D8, respectively.

The second drain region D2 of the second transistor T2 and the fifth drain region D5 of the fifth transistor T5 may extend from the first source region S1 of the first transistor T1. The sixth source region S6 of the sixth transistor T6 may extend from the first drain region D1 of the first transistor T1. The seventh source region S7 of the seventh transistor T7 may extend from the sixth drain region D6 of the sixth transistor T6.

Depending on this structure, the first transistor T1 may be connected to the second, fifth, and sixth transistors T2, T5, and T6, and the sixth transistor T6 may be connected to the seventh transistor T7.

The first semiconductor pattern SMP1 of the eighth transistor T8 may be adjacent to the first semiconductor pattern SMP1 of the fifth transistor T5. The first semiconductor pattern SMP1 of the eighth transistor T8 may be formed in an island shape.

The first and third source regions S1' and S3', the first and third drain regions D1' and D3', and the first and third channel regions A1' and A3' of the first and third transistors T1' and T3' may be formed by the first semiconductor pattern SMP1. The first and third channel regions A1' and A3' may be disposed between the first and third source regions S1' and S3' and the first and third drain regions D1' and D3', respectively. The third channel region A3' of the third transistor T3' may be formed of two channel regions.

The third source region S3' of the third transistor T3' may extend from the first drain region D1' of the first transistor T1'. Depending on this structure, the first transistor T1' may be connected to the third transistor T3'.

The first semiconductor pattern SMP1 of the first and third transistors T1' and T3' may be adjacent to the first semiconductor pattern SMP1 of the second transistor T2 in the second direction DR2.

In the following drawings, the ordinal numbers i-th and j-th representing the order of the above-described lines are omitted. That is, the layout will be described without limiting the lines to a specific order.

Referring to FIGS. 12A to 12C, a first gate pattern GPT1 may be disposed on the first semiconductor pattern SMP1. The first gate pattern GPT1 may include a write scan line GW, a light emission line EL, a bias scan line GB, the first gate electrode G1, and the first gate electrode G1'.

The write scan line GW, the light emission line EL, and the bias scan line GB may extend in the second direction DR2 and may be arranged in the first direction DR1. The light emission line EL may be disposed between the write scan line GW and the bias scan line GB. The first gate electrode G1 and the first gate electrode G1' may be disposed between the write scan line GW and the light emission line EL.

The first gate electrode G1 of the first transistor T1 may be formed by the first gate pattern GPT1. The first gate electrode G1 may overlap the first channel region A1.

The write scan line GW may extend to cross the first semiconductor pattern SMP1. The second gate electrode G2 of the second transistor T2 may be formed by the write scan line GW. A portion of the write scan line GW that overlaps the first semiconductor pattern SMP1 when viewed from above the plane may be defined as the second gate electrode G2. The second gate electrode G2 may overlap the second channel region A2 when viewed from above the plane.

The light emission line EL may extend to cross the first semiconductor pattern SMP1. The fifth gate electrode G5 of the fifth transistor T5 and the sixth gate electrode G6 of the sixth transistor T6 may be formed by the light emission line EL.

Portions of the light emission line EL that overlap the first semiconductor pattern SMP1 when viewed from above the plane may be defined as the fifth and sixth gate electrodes G5 and G6. When viewed from above the plane, the fifth gate electrode G5 may overlap the fifth channel region A5, and the sixth gate electrode G6 may overlap the sixth channel region A6.

The bias scan line GB may extend to cross the first semiconductor pattern SMP1. The seventh gate electrode G7 of the seventh transistor T7 and the eighth gate electrode G8 of the eighth transistor T8 may be formed by the bias scan line GB. Portions of the bias scan line GB that overlap the first semiconductor pattern SMP1 may be defined as the seventh and eighth gate electrodes G7 and G8. The seventh and eighth gate electrodes G7 and G8 may overlap the seventh and eighth channel regions A7 and A8, respectively.

The first gate electrode G1' of the first transistor T1' may be formed by the first gate pattern GPT1. The first gate electrode G1' may overlap the first channel region A1'.

The third gate electrode G3' of the third transistor T3' may be formed by the write scan line GW. A portion of the write scan line GW that overlaps the first semiconductor pattern SMP1 when viewed from above the plane may be defined as the third gate electrode G3'. The third gate electrode G3' may overlap the third channel region A3' when viewed from above the plane. The third gate electrode G3' may be formed of two gate electrodes.

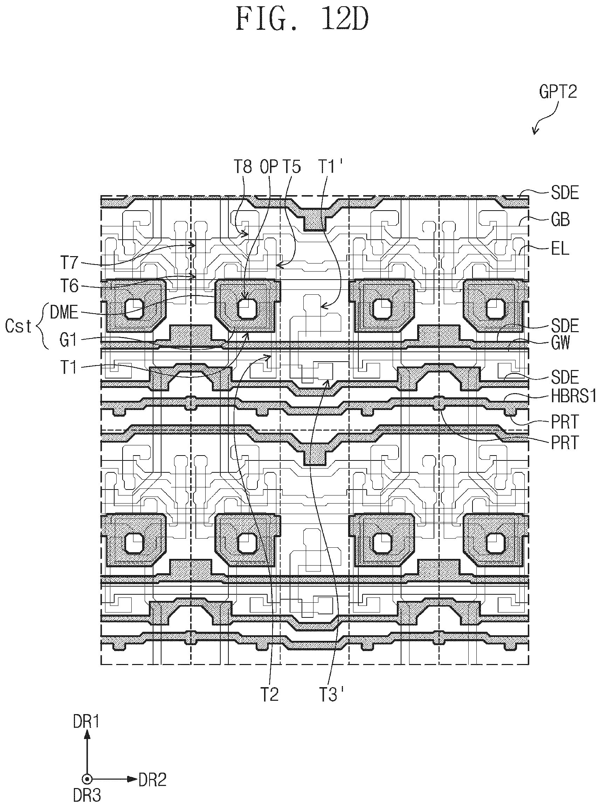

Hereinafter, in FIGS. 12D to 12I, for convenience of description and simplification of reference numerals, the reference numerals of the first, second, and fifth to eighth source regions S1, S2, and S5 to S8, the first, second, and fifth to eighth drain regions D1, D2, and D5 to D8, the first, second, and fifth to eighth channel regions A1, A2, and A5 to A8, and the first, second, and fifth to eighth gate electrodes G1, G2, and G5 to G8 will be omitted. In addition, the reference numerals of the first and third source regions S1' and S3', the first and third drain regions D1' and D3', the first and third channel regions A1' and A3', and the first and third gate electrodes G1' and G3' will also be omitted.

In FIGS. 12D to 12I, the reference numerals of the first, second, and fifth to eighth transistors T1, T2, and T5 to T8 and the first and third transistors T1' and T3' are illustrated.

Referring to FIGS. 12A to 12D, a second gate pattern GPT2 may be disposed on the first gate pattern GPT1. The second gate pattern GPT2 may include the dummy electrode DME, a plurality of sub-dummy electrodes SDE, and a first horizontal line HBRS1.

The dummy electrode DME may overlap the above-described first gate electrode G1 when viewed from the plane formed by the first direction DR1 and the second direction DR2. The dummy electrode DME may form the capacitor CST together with the first gate electrode G1. An opening OP may be defined in the dummy electrode DME.

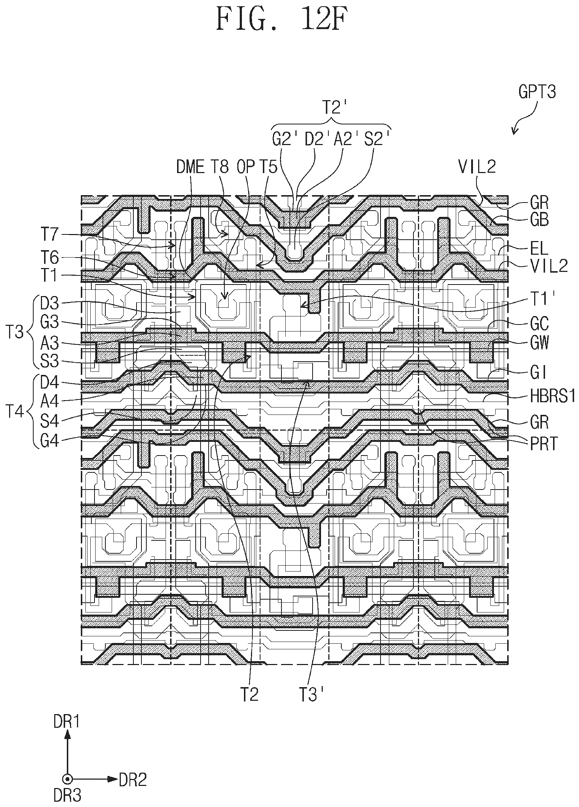

The sub-dummy electrodes SDE may extend in the second direction DR2 and may be arranged in the first direction DR1. When viewed from the DR1-DR2 plane, the sub-dummy electrodes SDE may overlap a reset scan line GR, a compensation scan line GC, and an initialization scan line GI illustrated in FIG. 12F.

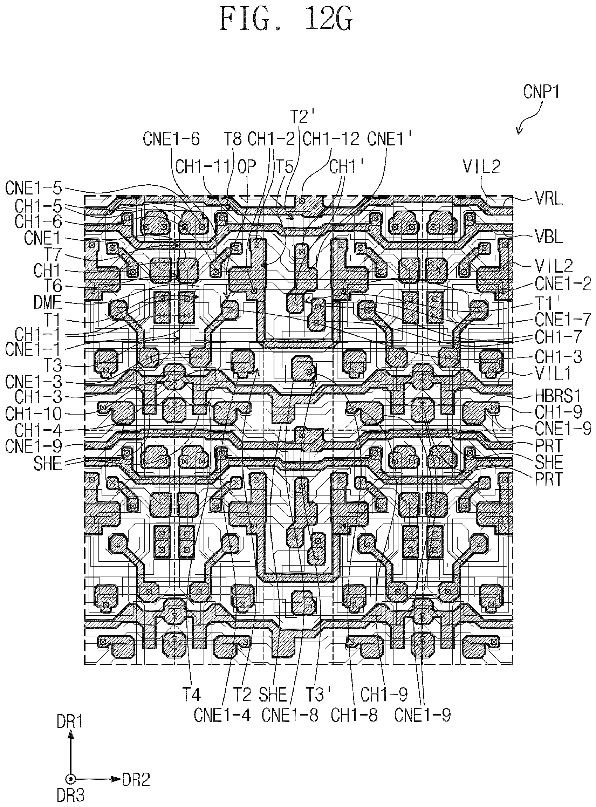

The first horizontal line HBRS1 may correspond to any one first horizontal line HBRS1 connected to the data line DL illustrated in FIG. 10. The first horizontal line HBRS1 may extend in the second direction DR2. The first horizontal line HBRS1 may be adjacent to lower sides of the pixel circuit PC and the sensing circuit SNC. A plurality of protrusions PRT may be defined on the first horizontal line HBRS1. The protrusions PRT may be connected to first connecting electrodes CNE illustrated in FIG. 12G.

Referring to FIGS. 12A to 12E, a second semiconductor pattern SMP2 may be disposed on the second gate pattern GPT2. The third and fourth source regions S3 and S4, the third and fourth drain regions D3 and D4, and the third and fourth channel regions A3 and A4 of the third and fourth transistors T3 and T4 may be formed by the second semiconductor pattern SMP2.

The third and fourth channel regions A3 and A4 may be disposed between the third and fourth source regions S3 and S4 and the third and fourth drain regions D3 and D4, respectively. The fourth drain region D4 of the fourth transistor T4 may extend from the third source region S3 of the third transistor T3. Depending on this structure, the fourth transistor T4 may be connected to the third transistor T3.

The second source region S2', the second drain region D2', and the second channel region A2' of the second transistor T2' may be formed by the second semiconductor pattern SMP2. The second channel region A2' may be disposed between the second source region S2' and the second drain region D2'.

Hereinafter, in FIGS. 12F to 12I, the reference numerals of the sub-dummy electrodes SDE will be omitted.

Referring to FIGS. 12A to 12F, a third gate pattern GPT3 may be disposed on the second semiconductor pattern SMP2. The third gate pattern GPT3 may include the reset scan line GR, the compensation scan line GC, the initialization scan line GI, and second initialization lines VIL2.

The reset scan line GR, the compensation scan line GC, the initialization scan line GI, and the second initialization lines VIL2 may extend in the second direction DR2 and may be arranged in the first direction DR1. The reset scan line GR, the compensation scan line GC, and the initialization scan line GI may be disposed to overlap the sub-dummy electrodes SDE illustrated in FIG. 12D, respectively.

The compensation scan line GC may be disposed between the initialization scan line GI and the reset scan line GR. The second initialization lines VIL2 may be disposed between the compensation scan line GC and the reset scan line GR. The second initialization lines VIL2 may be adjacent to the seventh and eighth transistors T7 and T8 and the first and second transistors T1' and T2'.

The compensation scan line GC may extend to cross the second semiconductor pattern SMP2. The third gate electrode G3 of the third transistor T3 may be formed by the compensation scan line GC. A portion of the compensation scan line GC that overlaps the second semiconductor pattern SMP2 when viewed from above the plane may be defined as the third gate electrode G3.

The initialization scan line GI may extend to cross the second semiconductor pattern SMP2. The fourth gate electrode G4 of the fourth transistor T4 may be formed by the initialization scan line GI. A portion of the initialization scan line GI that overlaps the second semiconductor pattern SMP2 when viewed from above the plane may be defined as the fourth gate electrode G4.

The reset scan line GR may extend to cross the second semiconductor pattern SMP2. The second gate electrode G2' of the second transistor T2' may be formed by the reset scan line GR. A portion of the reset scan line GR that overlaps the second semiconductor pattern SMP2 when viewed from above the plane may be defined as the second gate electrode G2'.

Hereinafter, in FIGS. 12G to 12I, for convenience of description and simplification of reference numerals, the reference numerals of the third and fourth source regions S3 and S4, the third and fourth drain regions D3 and D4, the third and fourth channel regions A3 and A4, and the third and fourth gate electrodes G3 and G4 will be omitted. Furthermore, the reference numerals of the second source region S2', the second drain region D2', the second channel region A2', and the second gate electrode G2' will also be omitted. In addition, in FIGS. 12G to 12I, the reference numerals of the write scan line GW, the compensation scan line GC, the initialization scan line GI, the bias scan line GB, and the reset scan line GR will also be omitted. In FIGS. 12G to 12I, the reference numerals of the first to eighth transistors T1 to T8 and the first to third transistors T1' to T3' are illustrated.

Referring to FIG. 12G, a first connecting pattern CNP1 may be disposed on the third gate pattern GPT3. The first connecting pattern CNP1 may include the first connecting electrodes CNE1, CNE1', and CNE1-1 to CNE1-9, the first initialization line VIL1, the reset line VRL, and the bias line VBL. The first connecting electrode CNE1 may be the first connecting electrode CEN1 illustrated in FIG. 6. The first connecting electrode CNE1' may be the first connecting electrode CEN1' illustrated in FIG. 7.

The first initialization line VIL1, the reset line VRL, and the bias line VBL may extend in the second direction DR2 and may be arranged in the first direction DR1. The first initialization line VIL1 may be adjacent to the fourth transistor T4. The reset line VRL may be adjacent to the second transistor T2'. The bias line VBL may be adjacent to the eighth transistor T8.

The first connecting electrodes CNE1, CNE1', and CNE1-1 to CNE1-9, the first initialization line VIL1, the reset line VRL, and the bias line VBL may be disposed in the same layer. The first connecting electrodes CNE1, CNE1', and CNE1-1 to CNE1-9, the first initialization line VIL1, the reset line VRL, and the bias line VBL may be simultaneously subjected to patterning and may be formed of the same material.

A plurality of first contact holes CH1, CH1', and CH1-1 to CH1-12 may be defined. The first contact hole CH1 may be the first contact hole CH1 illustrated in FIG. 6. Among the first contact holes CH1', the first contact hole CH1' overlapping the first gate electrode G1' may be the first contact hole CH1' illustrated in FIG. 7. The first contact holes CH1-1 to CH1-12 may be formed to be similar to the first contact hole CH1 or the first contact hole CH1' illustrated in FIGS. 6 and 7.

The first connecting electrode CNE1 may be connected to the sixth drain region D6 of the sixth transistor T6 through the first contact hole CH1.

The first connecting electrode CNE1' may be connected to the first gate electrode G1' of the first transistor T1' and the second source region S2' of the second transistor T2' through the first contact holes CH1'. The first transistor T1' and the second transistor T2' may be connected with each other through the first connecting electrode CNE1'.

The first connecting electrode CNE1-1 may be connected to the third transistor T3 and the first and sixth transistors T1 and T6 through the first contact holes CH1-1. The first connecting electrode CNE1-1 may be connected to the first drain region D1 of the first transistor T1, the sixth source region S6 of the sixth transistor T6, and the third drain region D3 of the third transistor T3. The third transistor T3 may be connected to the first and sixth transistors T1 and T6 by the first connecting electrode CNE1-3.

The first connecting electrode CNE1-2 may be connected to the fifth transistor T5 and the dummy electrode DME of the capacitor CST through the first contact holes CH1-2. The first connecting electrode CNE1-2 may be connected to the fifth source region S5 of the fifth transistor T5.

The first connecting electrode CNE1-3 may be connected to the third and fourth transistors T3 and T4 and the first gate electrode G1 of the first transistor T1 through the first contact holes CH1-3. The first connecting electrode CNE1-3 may be connected to the third source region S3 of the third transistor T3 and the fourth drain region D4 of the fourth transistor T4. The third and fourth transistors T3 and T4 may be connected to the first transistor T1 by the first connecting electrode CNE1-3.

A portion of the first gate electrode G1 may be exposed by the opening DOP formed in the dummy electrode DME. The first contact hole CH1-3 may be formed to overlap the opening OP, and the first connecting electrode CNE1-3 may be easily connected to the first gate electrode G1 accordingly.

The first connecting electrode CNE1-4 may be connected to the second transistor T2 through the first contact hole CH1-4. The first connecting electrode CNE1-4 may be connected to the second source region S2 of the second transistor T2.

The first connecting electrode CNE1-5 may be connected to the seventh transistor T7 and one second initialization line VIL2 through the first contact holes CH1-5. The first connecting electrode CNE1-5 may be connected to the seventh drain region D7 of the seventh transistor T7 through the first contact hole CH1-5. The seventh transistor T7 may be connected to the second initialization line VIL2 by the first connecting electrode CNE1-5.

The first connecting electrode CNE1-6 may be connected to the fifth transistor T5 and the eighth transistor T8 through the first contact holes CH1-6. The first connecting electrode CNE1-6 may be connected to the fifth drain region D5 of the fifth transistor T5 and the eighth drain region D8 of the eighth transistor T8 through the first contact holes CH1-6. The fifth transistor T5 may be connected to the eighth transistor T8 by the first connecting electrode CNE1-6.

The first connecting electrode CNE1-7 may be connected to the first transistor T1' and the one second initialization line VIL2 through the first contact holes CH1-7. The first connecting electrode CNE1-7 may be connected to the first source region S1' of the first transistor T1' through the first contact hole CH1-7. The first transistor T1' may be connected to the second initialization line VIL2 by the first connecting electrode CNE1-7.

The first connecting electrode CNE1-8 may be connected to the third transistor T3' through the first contact hole CH1-8. The first connecting electrode CNE1-8 may be connected to the third drain region D3' of the third transistor T3'.

Hereinafter, it will be described that a plurality of first connecting electrodes CNE1-9 and a plurality of shielding electrodes SHE are provided. For example, a configuration of the plurality of first connecting electrodes CNE1-9 and the plurality of shielding electrodes SHE that overlap the first horizontal line HBRS 1 will be described.

The plurality of first connecting electrodes CNE1-9 may be arranged in the second direction DR2 and may overlap the first horizontal line HBRS1. The first connecting electrodes CNE1-9 may overlap the pixel circuits PC and may not overlap the sensing circuit SNC.

The first connecting electrodes CNE1-9 may be connected to the first horizontal line HBRS1 through the first contact holes CH1-9. For example, the first connecting electrodes CNE1-9 may be connected to the protrusions PRT of the first horizontal line HBRS1 through the first contact holes CH1-9.

The first initialization line VII,1 may be connected to the fourth transistor T4. The first initialization line VII,1 may be connected to the fourth source region S4 of the fourth transistor T4 through the first contact hole CH1-10.

The plurality of shielding electrodes SHE may protrude from the first initialization line VIL1. The shielding electrodes SHE may be arranged in the second direction DR2. The shielding electrodes SHE may be disposed on the first horizontal line HBRS 1 and may overlap portions of the first horizontal line HBRS 1 when viewed from above the plane. The shielding electrodes SHE may be disposed between the first connecting electrodes CNE1-9 when viewed from above the plane. The first initialization voltage VINT, which is a constant voltage, may be applied to the shielding electrodes SHE protruding from the first initialization line VIL1.

The bias line VBL may be connected to the eighth transistor T8. The bias line VBL may be connected to the eighth source region S8 of the eighth transistor T8 through the first contact hole CH1-11.

The reset line VRL may be connected to the second transistor T2'. The reset line VRL may be connected to the second drain region D2' of the second transistor T2' through the first contact hole CH1-12.

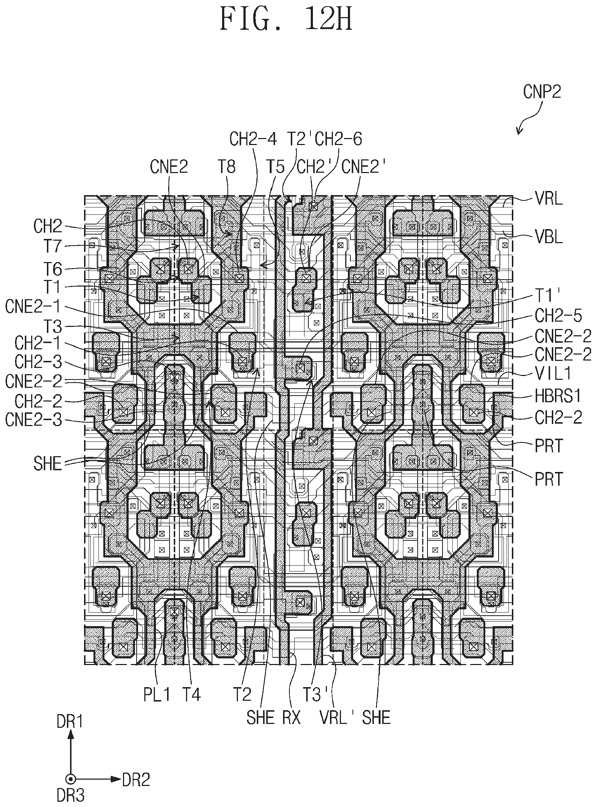

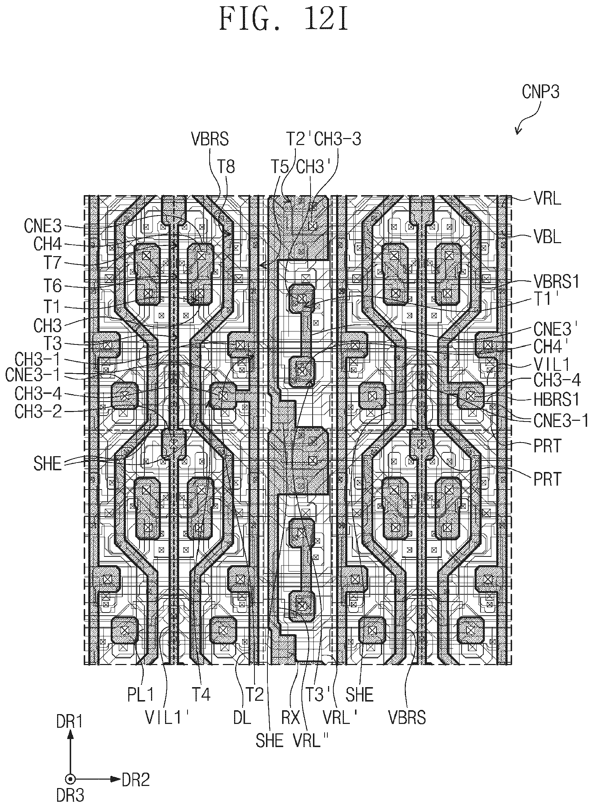

Hereinafter, in FIGS. 12H and 12I, for simplification of reference numerals, the reference numerals of the first connecting electrodes CNE1, CNE1', and CNE1-1 to CNE1-9, the first contact holes CH1, CH1', and CH1-1 to CH1-12, and the dummy electrode DME will be omitted.

Referring to FIGS. 12A to 12H, a second connecting pattern CNP2 may be disposed on the first connecting pattern CNP1. The second connecting pattern CNP2 may include second connecting electrodes CNE2, CNE2', and CNE2-1 to CNE2-3, the first power line PL1, the receiving line RX, and a reset line VRL'. The second connecting electrode CNE2 may be the same as the second connecting electrode CNE2 illustrated in FIG. 6. The second connecting electrode CNE2' may be the same as the second connecting electrode CEN2' illustrated in FIG. 7.

The first power line PL1 may extend in the first direction DR1 and may overlap the pixel circuit PC. The receiving line RX and the reset line VRL' may extend in the first direction DR1. The receiving line RX and the reset line VRL' may be spaced apart from each other in the second direction DR2 and may overlap the sensing circuit SNC.

The second connecting electrodes CNE2, CNE2', and CNE2-1 to CNE2-3, the first power line PL1, the receiving line RX, and the reset line VRL' may be disposed in the same layer. The second connecting electrodes CNE2, CNE2', and CNE2-1 to CNE2-3, the first power line PL1, the receiving line RX, and the reset line VRL' may be simultaneously subjected to patterning and may be formed of the same material.

A plurality of second contact holes CH2, CH2', and CH2-1 to CH2-6 may be defined. The second contact hole CH2 may be the same as the second contact hole CH2 illustrated in FIG. 6. The second contact hole CH2' may be the same as the second contact hole CH2' illustrated in FIG. 7. The second contact holes CH2-1 to CH2-6 may be formed to be similar to the second contact holes CH2 and CH2' illustrated in FIGS. 6 and 7.

The second connecting electrode CNE2 may be connected to the first connecting electrode CNE1 through the second contact hole CH2. Accordingly, the second connecting electrode CNE2 may be connected to the sixth transistor T6 through the first connecting electrode CNE1.

The second connecting electrode CNE2' may be connected to the first connecting electrode CNE1' through the second contact hole CH2'. Accordingly, the second connecting electrode CNE2' may be connected to the second transistor T2' through the first connecting electrode CNE1'.

The second connecting electrode CNE2-1 may be connected to the first connecting electrode CNE1-4 through the second contact hole CH2-1. Accordingly, the second connecting electrode CNE2-1 may be connected to the second transistor T2 through the first connecting electrode CNE1-4.

Hereinafter, similarly to the first connecting electrodes CNE1-9 and the shielding electrodes SHE, a plurality of second connecting electrodes CNE2-2 are provided. For example, a configuration of the plurality of second connecting electrodes CNE2-2 overlapping the first horizontal line HBRS1 will be described.

The plurality of second connecting electrodes CNE2-2 may overlap some of the first connecting electrodes CNE1-9. The second connecting electrodes CNE2-2 may be connected to the some of the first connecting electrodes CNE1-9 through the second contact hole CH2-2. Accordingly, the second connecting electrodes CNE2-2 may be connected to the first horizontal line HBRS1 through the some of the first connecting electrodes CNE1-9.

The second connecting electrode CNE2-3 may be connected to the first initialization line VII,1 through the second contact hole CH2-3. In FIG. 12H, the second connecting electrodes CNE2-3 may be disposed on the left and right sides. The second connecting electrode CNE2-3 on the left side may be connected to the first initialization line VIL1, whereas the second connecting electrode CNE2-3 on the right side may not be connected to the first initialization line VIL1. Accordingly, the second contact hole CH2-3 may not be defined in the second connecting electrode CNE2-3 on the right side.

The first power line PL1 may be connected to the first connecting electrode CNE1-2 through the second contact hole CH2-4. Accordingly, the first power line PL1 may be connected to the fifth transistor T5 and the dummy electrode DME through the first connecting electrode CNE1-2.

The receiving line RX may be connected to the first connecting electrode CNE1-8 through the second contact hole CH2-5. Accordingly, the receiving line RX may be connected to the third transistor T3' through the first connecting electrode CNE1-8.

The reset line VRL' may be connected to the reset line VRL through the second contact hole CH2-6. The reset line VRL' may be connected to the second transistor T2' through the reset line VRL.

Hereinafter, in FIG. 12I, for simplification of reference numerals, the reference numerals of the second connecting electrodes CNE2, CNE2', and CNE2-1 to CNE2-3 and the second contact holes CH2, CH2', and CH2-1 to CH2-6 will be omitted.

Referring to FIGS. 12A to 12I, a third connecting pattern CNP3 may be disposed on the second connecting pattern CNP2. The third connecting pattern CNP3 may include a plurality of third connecting electrodes CNE3, CNE3', and CNE3-1, the data line DL, a reset line VRL", a first initialization line VIL1', and the vertical line VBRS.

The third connecting electrode CNE3 may be the same as the third connecting electrode CNE3 illustrated in FIG. 6. The third connecting electrode CNE3' may be the same as the third connecting electrode CEN3' illustrated in FIG. 7.

The data line DL, the reset line VRL", the first initialization line VIL1', and the vertical line VBRS may extend in the first direction DR1 and may be arranged in the second direction DR2. The data line DL, the first initialization line VIL1', and the vertical line VBRS may overlap the pixel circuit PC, and the reset line VRL" may overlap the sensing circuit SNC.

The third connecting electrode CNE3 may be disposed between the first initialization line VIL1' and the vertical line VBRS. The data line DL may be disposed between the vertical line VBRS and the reset line VRL".

The third connecting electrodes CNE3, CNE3', and CNE3-1, the data line DL, the reset line VRL", the first initialization line VIL1', and the vertical line VBRS may be disposed in the same layer. The third connecting electrodes CNE3, CNE3', and CNE3-1, the data line DL, the reset line VRL", the first initialization line VIL1', and the vertical line VBRS may be simultaneously subjected to patterning and may be formed of the same material.

A plurality of third contact holes CH3, CH3', and CH3-1 to CH3-4 may be defined. The third contact hole CH3 may be the third contact hole CH3 illustrated in FIG. 6. The third contact hole CH3' may be the third contact hole CH3' illustrated in FIG. 7. The third contact holes CH3-1 to CH3-4 may be formed to be similar to the third contact holes CH3 and CH3' illustrated in FIGS. 6 and 7.

A plurality of fourth contact holes CH4 and CH4' may be defined. The fourth contact hole CH4 may be the fourth contact hole CH4 illustrated in FIG. 6. The fourth contact hole CH4' may be the fourth contact hole CH4' illustrated in FIG. 7.

The third connecting electrode CNE3 may be connected to the second connecting electrode CNE2 through the third contact hole CH3. The third connecting electrode CNE3 may be connected to the first electrode AE illustrated in FIG. 6 through the fourth contact hole CH4. Accordingly, the first electrode AE may be connected to the sixth transistor T6 through the first connecting electrode CNE1, the second connecting electrode CNE2, and the third connecting electrode CNE3.

The third connecting electrode CNE3' may be connected to the second connecting electrode CNE2' through the third contact hole CH3'. The third connecting electrode CNE3' may be connected to the first electrode AE' illustrated in FIG. 7 through the fourth contact hole CH4'. Accordingly, the first electrode AE' may be connected to the second transistor T2' through the first connecting electrode CNE1', the second connecting electrode CNE2', and the third connecting electrode CNE3' .

The data line DL may be connected to the second connecting electrode CNE2-1 through the third contact hole CH3-1. Accordingly, the data line DL may be connected to the second transistor T2 through the first connecting electrode CNE1-4 and the second connecting electrode CNE2-1.

The first initialization line VII,1' may be connected to the second connecting electrode CNE2-3 through the third contact hole CH3-2. Accordingly, the first initialization line VIL1' may be connected to the first initialization line VII,1 through the second connecting electrode CNE2-3. The first initialization voltage VINT may be provided to the fourth transistor T4 by the first initialization line VII,1' and the first initialization line VIL1.

The reset line VRL" may be connected to the reset line VRL' through the third contact hole CH3-3. The reset line VRL" may be connected to the reset line VRL through the reset line VRL'. The reset voltage VRST may be provided to the second transistor T2' by the reset line VRL, the reset line VRL', and the reset line VRL". The reset line VRL" may overlap the receiving line RX.

The data lines DL may be disposed on the left and right sides of the reset line VRL". The reset line VRL" may be disposed between the data lines DL. Data voltages applied to the data lines DL may be pulsed signals. The pulsed signals may affect the sensing signal RS output through the receiving line RX. When viewed from above the plane, the reset line VRL" may be disposed between the data lines DL, may overlap the receiving line RX, and may block an influence of the pulsed data voltages on the sensing signal RS. That is, the reset line VRL" may serve as a shielding electrode.

Hereinafter, in FIG. 12I, it will be described that a plurality of third connecting electrodes CNE3-1 and a plurality of vertical lines VBRS are provided.

The plurality of third connecting electrodes CNE3-1 may overlap the second connecting electrodes CNE2-2, respectively. The third connecting electrodes CNE3-1 may be connected to the second connecting electrodes CNE2-2 through the third contact holes CH3-4, respectively. The third connecting electrodes CNE3-1 may be connected to the first horizontal line HBRS1 through the second connecting electrodes CNE2-2 and some of the first connecting electrodes CNE1-9.

The data line DL may be connected to a corresponding third connecting electrode CNE3-1 among the third connecting electrodes CNE3-1. For example, the data line DL may be integrally formed with the corresponding third connecting electrode CNE3-1. The third connecting electrode CNE3-1 corresponding to the data line DL may extend from the data line DL. The data line DL may be connected to the first horizontal line HBRS1 through the corresponding third connecting electrode CNE3-1.

The plurality of vertical lines VBRS may extend in the first direction DR1 and may be arranged in the second direction DR2. Among the vertical lines VBRS, the rightmost first vertical line VBRS1 may be connected to a corresponding third connecting electrode CNE3-1 among the third connecting electrodes CNE3-1. For example, the first vertical line VBRS1 may be integrally formed with the corresponding third connecting electrode CNE3-1. The third connecting electrode CNE3-1 corresponding to the first vertical line VBRS1 may extend from the first vertical line VBRS1. The first vertical line VBRS1 may be connected to the first horizontal line HBRS1 through the corresponding third connecting electrode CNE3-1.

Depending on this structure, as described with reference to FIG. 10, the first vertical line VBRS1 may be connected to the first horizontal line HBRS1, and the first horizontal line HBRS1 may be connected to the data line DL.

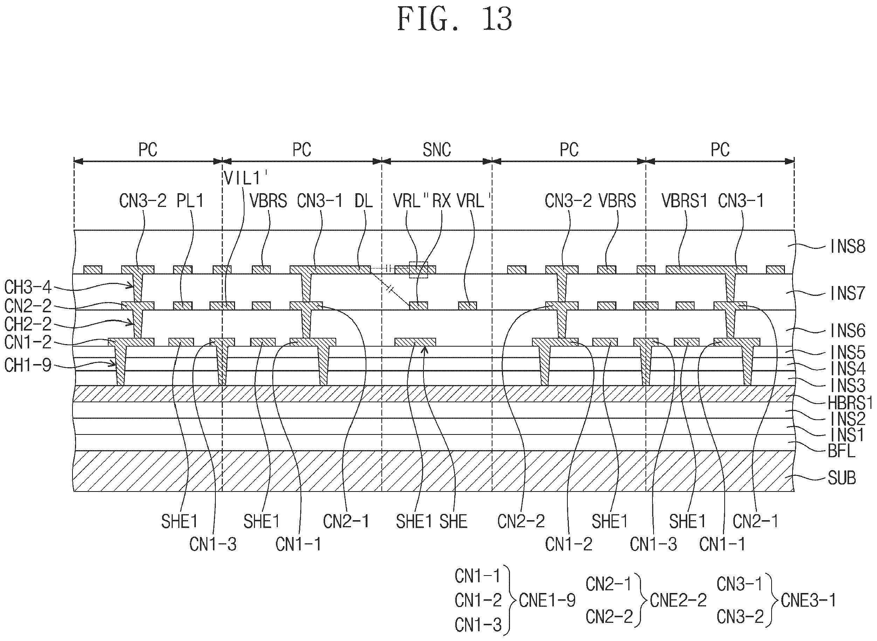

FIG. 13 is a view illustrating a sectional configuration of the first horizontal line and the electrodes connected to the first horizontal line illustrated in FIG. 12I.

FIG. 13 illustrates a section formed in the extension direction of the first horizontal line HBRS1. In FIG. 13, the sections of the connecting electrodes connected to the first horizontal line HBRS1 and the sections of the lines around the first horizontal line HBRS1 are illustrated together with the section of the first horizontal line HBRS 1. For convenience of description, the components under the first horizontal line HBRS1 are omitted.

Referring to FIG. 12I and 13, the first horizontal line HBRS1 may be disposed on the second insulating layer INS2, and the third, fourth, and fifth insulating layers INS3, INS4, and INS5 may be disposed on the first horizontal line HBRS1.

The first connecting electrodes CNE1-9 may be disposed on the fifth insulating layer INS5. The first connecting electrodes CNE1-9 may be connected to the first horizontal line HBRS1 through the first contact holes CH1-9 defined in the third, fourth, and fifth insulating layers INS3, INS4, and INS5. The sixth insulating layer INS6 may be disposed on the first connecting electrodes CNE1-9.

The second connecting electrodes CNE2-2 may be disposed on the sixth insulating layer INS6. The second connecting electrodes CNE2-2 may be connected to the first connecting electrodes CNE1-9 through the second contact holes CH2-2 defined in the sixth insulating layer INS6.

The seventh insulating layer INS7 may be disposed on the second connecting electrodes CNE2-2. The third connecting electrodes CNE3-1 may be disposed on the seventh insulating layer INS7. The third connecting electrodes CNE3-1 may be connected to the second connecting electrodes CNE2-2 through the third contact holes CH3-4 defined in the seventh insulating layer INS7. The eighth insulating layer INS8 may be disposed on the third connecting electrodes CNE3-1.

In the above-described stacked structure, the first vertical line VBRS1 and the data line DL may be disposed in the same layer. The receiving line RX may be disposed in a layer different from the layer in which the first vertical line VBRS1 and the data line DL are disposed. The receiving line RX may be disposed below the first vertical line VBRS1 and the data line DL.

The first horizontal line HBRS1 may be disposed below the first vertical line VBRS1, the data line DL, and the receiving line RX. The shielding electrodes SHE may be disposed in a layer between the receiving line RX and the first horizontal line HBRS1.

The first connecting electrodes CNE1-9 may include a plurality of first-first connecting electrodes CN1-1, a plurality of first-second connecting electrodes CN1-2, and a plurality of first-third connecting electrodes CN1-3. The first-first, first-second, and first-third connecting electrodes CN1-1, CN1-2, and CN1-3 may be disposed over the first horizontal line HBRS1 and may be connected to the first horizontal line HBRS1.

The shielding electrodes SHE may be disposed in the same layer as the first-first, first-second, and first-third connecting electrodes CN1-1, CN1-2, and CN1-3. The shielding electrodes SHE may include a plurality of first shielding electrodes SHE1 disposed between the first-first, first-second, and first-third connecting electrodes CN1-1, CN1-2, and CN1-3.

The shielding electrodes SHE may overlap the first horizontal lines HBRS1 when viewed from the plane DR1-DR2. In addition, among the shielding electrodes SHE, the shielding electrode SHE disposed in the sensing circuit SNC may overlap the receiving line RX when viewed the plane DR1-DR2.

The first-first connecting electrodes CN1-1 may overlap the data line DL and the first vertical line VBRS1 when viewed from the plane DR1-DR2. Connecting electrodes may be disposed over the first-second connecting electrodes CN1-2, and connecting electrodes may not be disposed over the first-third connecting electrodes CN1-3. This configuration will be described below in detail.

Each of the first-third connecting electrodes CN1-3 may be disposed between a corresponding first-first connecting electrode CN1-1 among the first-first connecting electrodes CN1-1 and a corresponding first-second connecting electrode CN1-2 among the first-second connecting electrodes CN1-2.

The connecting electrodes CNE2-2 may include a plurality of second-first connecting electrodes CN2-1 and a plurality of second-second connecting electrodes CN2-2. The receiving line RX may be disposed in the same layer as the second-first and second-second connecting electrodes CN2-1 and CN2-2.

The second-first connecting electrodes CN2-1 may be disposed abover the first-first connecting electrodes CN1-1 and may be connected to the first-first connecting electrodes CN1-1, respectively. The second-second connecting electrodes CN2-2 may be disposed above the first-second connecting electrodes CN1-2 and may be connected to the first-second connecting electrodes CN1-2, respectively.

The connecting electrodes CNE3-1 may include a plurality of third-first connecting electrodes CN3-1 and a plurality of third-second connecting electrodes CN3-2. The data line DL and the first vertical line VBRS1 may be disposed in the same layer as the third-first and third-second connecting electrodes CN3-1 and CN3-2.

The third-first connecting electrodes CN3-1 may be integrally formed with the data line DL and the first vertical line VBRS1, respectively. For example, the third-first connecting electrodes CN3-1 may extend from the data line DL and the first vertical line VBRS1, respectively.

The data line DL and the first vertical line VBRS1 may be connected to the second-first connecting electrodes CN2-1, respectively. For example, the third-first connecting electrodes CN3-1 extending from the data line DL and the first vertical line VBRS1 may be disposed above the second-first connecting electrodes CN2-1 and may be connected to the second-first connecting electrodes CN2-1, respectively. The third-second connecting electrodes CN3-2 may be disposed above the second-second connecting electrodes CN2-2 and may be connected to the second-second connecting electrodes CN2-2, respectively.

Depending on this structure, the first vertical line VBRS1 may be connected to the first horizontal line HBRS1 through the corresponding first-first and second-first connecting electrodes CN1-1 and CN2-1, and the first horizontal line HBRS1 may be connected to the data line DL through the corresponding first-first and second-first connecting electrodes CN1-1 and CN2-1.

The second-first and second-second connecting electrodes CN2-1 and CN2-2 and the third-first and third-second connecting electrodes CN3-1 and CN3-2 may not be disposed above the first-third connecting electrodes CN1-3. For example, when viewed from the plane DR1-DR2, the second-first and second-second connecting electrodes CN2-1 and CN2-2 and the third-first and third-second connecting electrodes CN3-1 and CN3-2 may not overlap the first-third connecting electrodes CN1-3. The second-second connecting electrodes CN2-2 and the third-second connecting electrodes CN3-2 may not overlap the data line DL and the receiving line RX when viewed from the plane DR1-DR2.

The reset line VRL" may be disposed over the receiving line RX and may overlap the receiving line RX. The reset line VRL" may be adjacent to the data line DL.

The above-described data voltage VD may be applied to the data line DL through the first vertical line VBRS1 and the first horizontal line HBRS 1.

The data voltage VD applied to the first vertical line VBRS1, the first horizontal line HBRS1, and the data line DL may be a pulsed signal. The pulsed signal may affect the sensing signal RS output through the receiving line RX. In this case, noise of the sensing signal RS may be increased, and therefore sensing sensitivity may be lowered. That is, the signal-to-noise ratio (SNR) of the sensing signal RS may be deteriorated.

In the layer structure, the shielding electrodes SHE may be disposed between the first horizontal line HBRS1 to which the data voltage VD is applied and the receiving line RX. In an embodiment of the present disclosure, the shielding electrodes SHE, to which a constant voltage is applied, may block an influence of the pulsed data voltage VD applied to the first horizontal line HBRS 1 on the sensing signal RS of the receiving line RX.

If the receiving line RX is disposed within a dotted box in Figure 13 marked on the rest line VRL in the same layer as the data line DL, the receiving line RX may be closer to the data line DL than when the receiving line RX is disposed in the layer different from the layer in which the data line DL is disposed. When the receiving line RX is disposed within the dotted box marked on the rest line VRL", the reset line VRL" may be disposed in another location.

When the receiving line RX is close to the data line DL, the capacitance of a parasitic capacitor (illustrated by dotted lines connecting to the data line DL) formed by the receiving line RX and the data line DL may be increased. As the capacitance of the parasitic capacitor is increased, noise of the sensing signal RS may be increased depending on the influence of the pulsed data voltage VD. This phenomenon may be defined as a coupling phenomenon.

In an embodiment of the present disclosure, the receiving line RX may be disposed below the data line DL without being disposed in the same layer as the data line DL. In this case, the receiving line RX may be spaced farther away from the data line DL than when the receiving line RX is disposed in the same layer as the data line DL. The capacitance of the parasitic capacitor (illustrated by dotted lines) formed by the receiving line RX and the data line DL may be decreased. Accordingly, the coupling phenomenon may be reduced, and thus noise of the sensing signal RS may be reduced.

In an embodiment of the present disclosure, the reset line VRL", to which a constant voltage is applied, may be adjacent to the data line DL and may be disposed above the receiving line RX to overlap the receiving line RX. The reset line VRL" may additionally block an effect of the pulsed data voltage VD applied to the data line DL on the sensing signal RS of the receiving line RX.

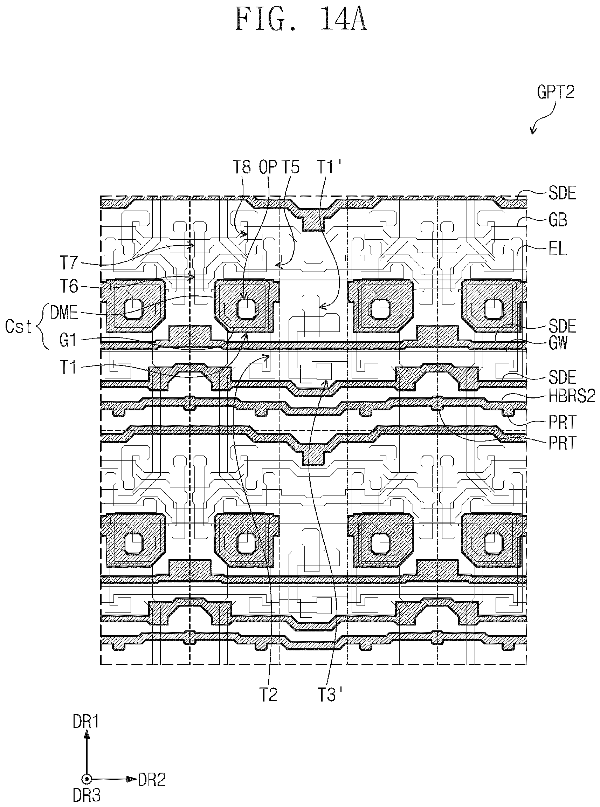

FIGS. 14A to 14D are views illustrating planar structures of pixel circuits and sensor circuits.

FIGS. 14A to 14D are views illustrating a configuration in which the receiving line RX, the second vertical data line VBRS2, and the second horizontal data line HBRS2 illustrated in FIG. 11 are connected with one another in the pixel circuits PC and the sensor circuits SNC.

Components illustrated in FIGS. 14A to 14D are the same as the components illustrated in FIGS. 12A to 12I, except for some components. Accordingly, the following description will be focused on the components different from the components illustrated in FIGS. 12A to 12I.

FIG. 14A may correspond to the plan view of FIG. 12D but for another embodiment. The lower conductive pattern BMP, the first semiconductor pattern SMP1, the first gate pattern GPT1, and the second gate pattern GPT may be substantially the same as those illustrated in FIGS. 12A to 12D.

However, the second gate pattern GPT2 may include the second horizontal line HBRS2. Like the first horizontal line HBRS1, the second horizontal line HBRS2 may have a plurality of protrusions PRT defined thereon. The second horizontal line HBRS2 may correspond to any one second horizontal line HBRS2 connected to the receiving line RX illustrated in FIG. 11.

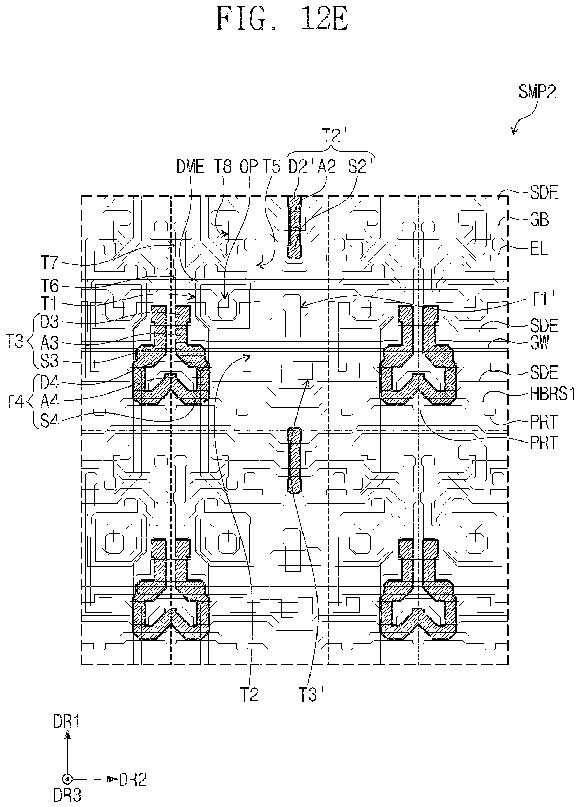

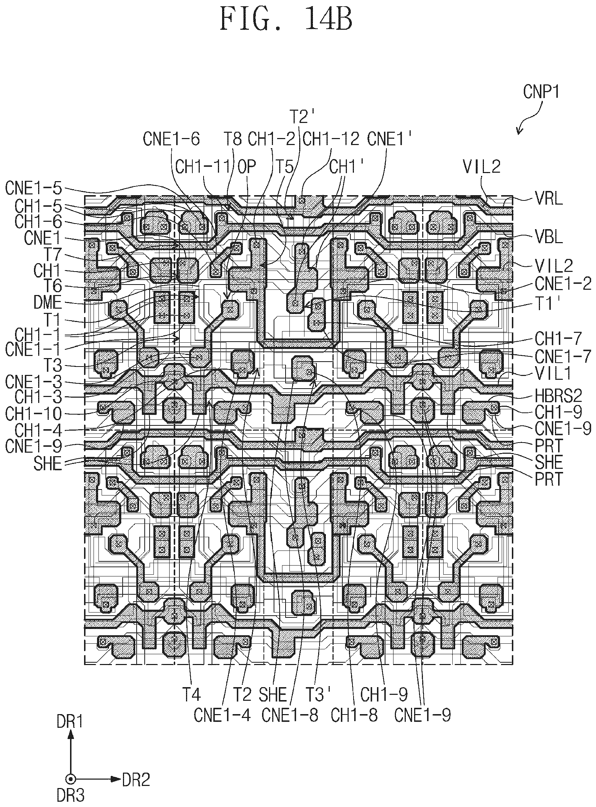

FIG. 14B may correspond to the plan view of FIG. 12G but for another embodiment. The second semiconductor pattern SMP2, the third gate pattern GPT3, and the first connecting pattern CNP1 may be substantially the same as those illustrated in FIGS. 12E to 12G. The first connecting electrodes CNE1-9 may be arranged in the second direction DR2 and may overlap the second horizontal line HBRS2. The first connecting electrodes CNE1-9 may be connected to the second horizontal line HBRS2 through the first contact holes CH1-9.

The shielding electrodes SHE may protrude from the first initialization line VIL1 and may overlap portions of the second horizontal line HBRS2. The shielding electrodes SHE may be disposed between the first connecting electrodes CNE1-9 when viewed from above the plane.

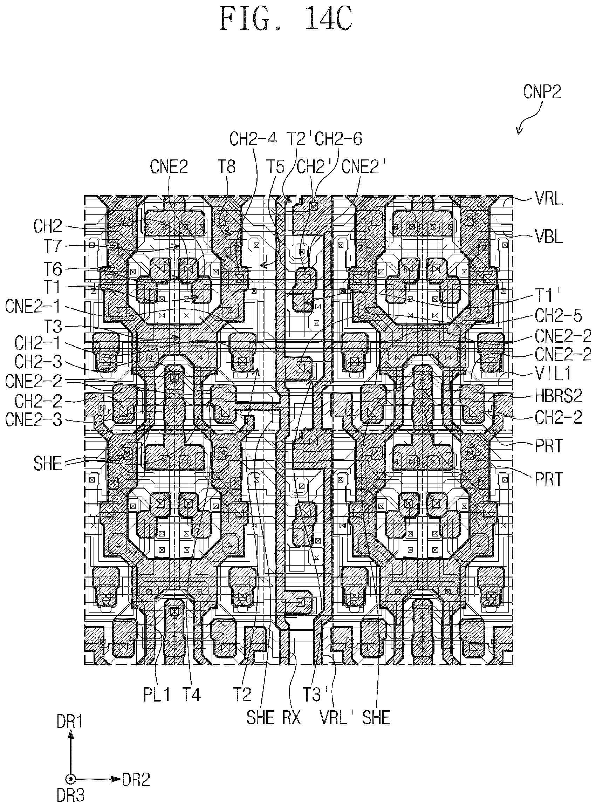

FIG. 14C may correspond to the plan view of FIG. 12H but for another embodiment. The second connecting pattern CNP2 illustrated in FIG. 14C may be the same as that illustrated in FIG. 12H, except for the configuration of the receiving line RX.

The second connecting electrodes CNE2-2 may be connected to some of the first connecting electrodes CNE1-9 through the second contact holes CH2-2. Accordingly, the second connecting electrodes CNE2-2 may be connected to the second horizontal line HBRS2 through the some of the first connecting electrodes CNE1-9.

The receiving line RX may be connected to a corresponding second connecting electrode CNE2-2 among the second connecting electrodes CNE2-2. Substantially, the receiving line RX may be integrally formed with the corresponding second connecting electrode CNE2-2. The receiving line RX may be connected to the second horizontal line HBRS2 through the corresponding second connecting electrode CNE2-2.

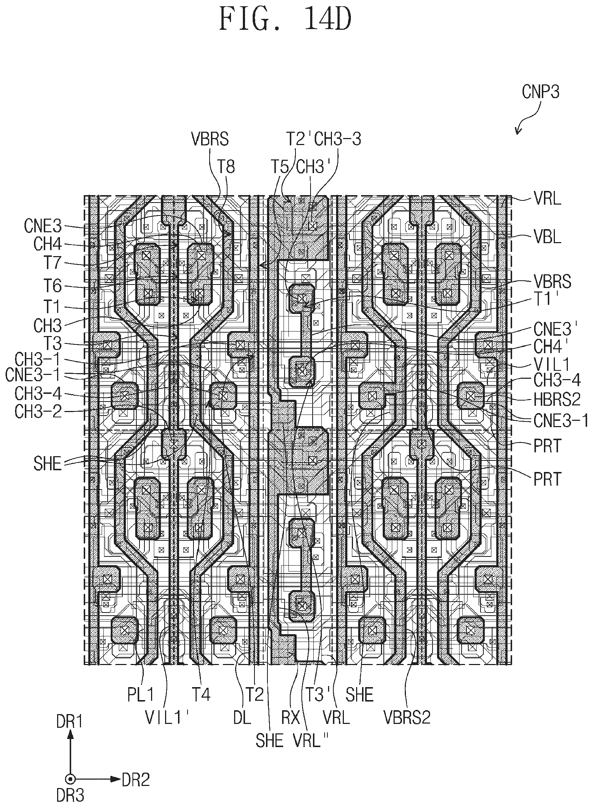

Referring to FIG. 14D, FIG. 14D may correspond to the plan view of FIG. 12I. The third connecting pattern CNP3 illustrated in FIG. 14D may be the same as that illustrated in FIG. 12I, except for the configuration of the data line DL and the second vertical line VBRS2.

The third connecting electrodes CNE3-1 may be connected to the second connecting electrodes CNE2-2 through the third contact holes CH3-4, respectively. The data line DL may not be connected to the third connecting electrodes CNE3-1. The receiving line RX may be connected to a corresponding third connecting electrode CNE3-1 through a corresponding second connecting electrode CNE2-2.

Among the vertical lines VBRS, the second vertical line VBRS2 that is second from the right may be connected to a corresponding third connecting electrode CNE3-1 among the third connecting electrodes CNE3-1. For example, the second vertical line VBRS2 may be integrally formed with the corresponding third connecting electrode CNE3-1. The second vertical line VBRS2 may be connected to the second horizontal line HBRS2 through the corresponding third connecting electrode CNE3-1.

Depending on this structure, as described with reference to FIG. 11, the second vertical line VBRS2 may be connected to the second horizontal line HBRS2, and the second horizontal line HBRS2 may be connected to the receiving line RX.

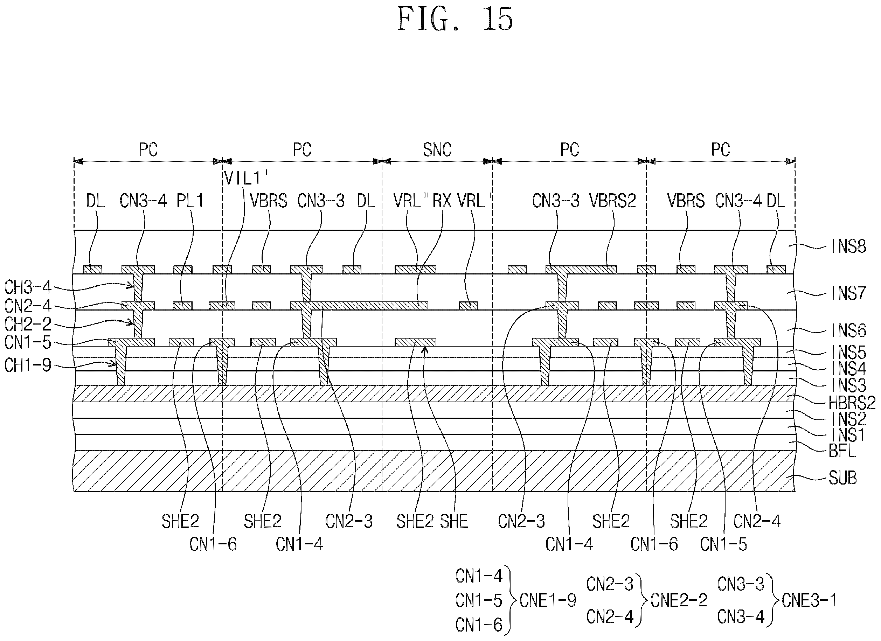

FIG. 15 is a view illustrating a sectional configuration of the second horizontal line and the electrodes connected to the second horizontal line illustrated in FIG. 14D.

FIG. 15 may be a sectional view corresponding to FIG. 13 but for another embodiment. The following description will be focused on components different from the components illustrated in FIG. 13.

Referring to FIGS. 13, 14D, and 15, the second horizontal line HBRS2 may be disposed in the same layer as the first horizontal line HBRS1, and the second vertical line VBRS2 may be disposed in the same layer as the first vertical line VBRS 1.

The first connecting electrodes CNE1-9 may include a plurality of first-fourth connecting electrodes CN1-4, a plurality of first-fifth connecting electrodes CN1-5, and a plurality of first-sixth connecting electrodes CN1-6. The first-fourth, firth-fifth, and firth-sixth connecting electrodes CN1-4, CN1-5, and CN1-6 may be disposed above the second horizontal line HBRS2 and may be connected to the second horizontal line HBRS2.

The first-fourth connecting electrodes CN1-4, the first-fifth connecting electrodes CN1-5, and the first-sixth connecting electrodes CN1-6 may be substantially the same as the first-first connecting electrodes CN1-1, the first-second connecting electrodes CN1-2, and the first-third connecting electrodes CN1-3, respectively.

The shielding electrode SHE may be disposed in the same layer as the first-fourth, firth-fifth, and firth-sixth connecting electrodes CN1-4, CN1-5, and CN1-6. The shielding electrode SHE may include a plurality of second shielding electrodes SHE2 disposed between the first-fourth, firth-fifth, and firth-sixth connecting electrodes CN1-4, CN1-5, and CN1-6.

The second connecting electrodes CNE2-2 may include a plurality of second-third connecting electrodes CN2-3 and a plurality of second-fourth connecting electrodes CN2-4. The receiving line RX may be disposed in the same layer as the second-third and second-fourth connecting electrodes CN2-3 and CN2-4.

The second-third connecting electrodes CN2-3 may be disposed abover the first-fourth connecting electrodes CN1-4 and may be connected to the first-fourth connecting electrodes CN1-4, respectively. The second-fourth connecting electrodes CN2-4 may be disposed above the first-fifth connecting electrodes CN1-5 and may be connected to the first-fifth connecting electrodes CN1-5, respectively.

The receiving line RX may be integrally formed with a corresponding second-third connecting electrode CN2-3 among the second-third connecting electrodes CN2-3. For example, the second-third connecting electrode CN2-3 corresponding to the receiving line RX may extend from the receiving line RX. The receiving line RX may be connected to a corresponding first-fourth connecting electrode CN1-4 through the corresponding second-third connecting electrode CN2-3.

The third connecting electrodes CNE3-1 may include a plurality of third-third connecting electrodes CN3-3 and a plurality of third-fourth connecting electrodes CN3-4. The third-third connecting electrodes CN3-3 may be disposed above the second-third connecting electrodes CN2-3 and may be connected to the second-third connecting electrodes CN2-3, respectively. The third-fourth connecting electrodes CN3-4 may be disposed above the second-fourth connecting electrodes CN2-4 and may be connected to the second-fourth connecting electrodes CN2-4, respectively.

The second vertical line VBRS2 may be disposed in the same layer as the third-third and third-fourth connecting electrodes CN3-3 and CN3-4. The second vertical line VBRS2 may be connected to a second-third connecting electrode CN2-3 not extending from the receiving line RX among the second-third connecting electrodes CN2-3. Among the third-third connecting electrodes CN3-3, a third-third connecting electrode CN3-3 connected to the second-third connecting electrode CN2-3 not extending from the receiving line RX may be defined as a third-third connecting electrode CN3-3 corresponding to the second vertical line VBRS2.

The second vertical line VBRS2 may be integrally formed with the third-third connecting electrode CN3-3 corresponding to the second vertical line VBRS2. For example, the third-third connecting electrode CN3-3 corresponding to the second vertical line VBRS2 may extend from the second vertical line VBRS2. The second vertical line VBRS2 may be connected to the corresponding second-third connecting electrode CN2-3 through the corresponding third-third connecting electrode CN3-3.

Depending on this structure, the second vertical line VBRS2 may be connected to the second horizontal line HBRS2 through the corresponding first-fourth and second-third connecting electrodes CN1-4 and CN2-3, and the second horizontal line HBRS2 may be connected to the receiving line RX through the corresponding first-fourth and second-third connecting electrodes CN1-4 and CN2-3. The above-described sensing signal RX may be output through the receiving line RX, the second horizontal line HBRS2, and the second vertical line VBRS2.

In an embodiment of the present disclosure, the shielding electrodes SHE may be disposed between the data lines DL and the second horizontal line HBRS2 along the third direction DR3. The shielding electrodes SHE may block an effect of the data voltages VD applied to the data lines DL on the sensing signal RS output through the second horizontal line HBRS2.

In addition, similarly to that described above, the reset line VRL" adjacent to the data line DL and disposed above the receiving line RX to overlap the receiving line RX may block an influence of the data voltage VD on the sensing signal RS of the receiving line RX.

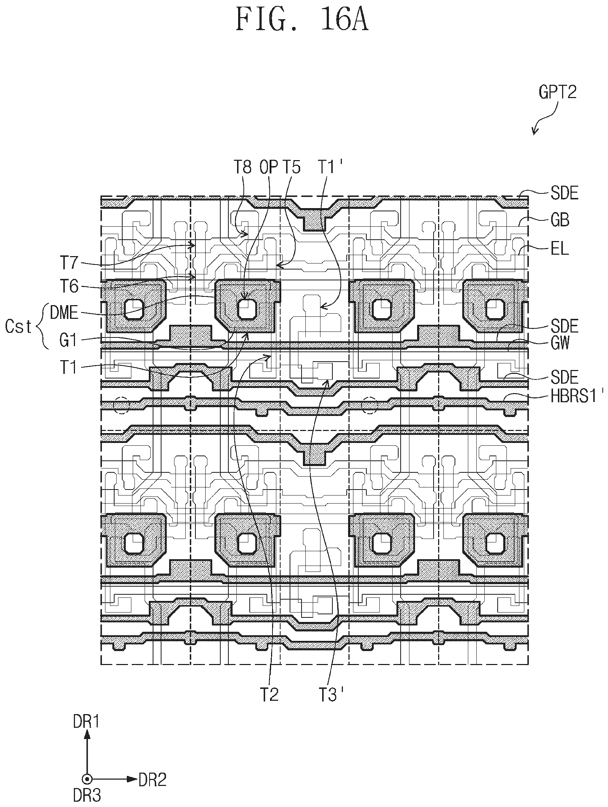

FIGS. 16A to 16D are views illustrating a modified embodiment of the layout illustrated in FIGS. 12A to 12I.

Hereinafter, components illustrated in FIGS. 16A to 16D will be described. The following description will be focused on components different from the components illustrated in FIGS. 12A to 12I.

FIG. 16A may correspond to the plan view of FIG. 12D but for another embodiment. In this embodiment, a configuration of a first horizontal line HBRS1' may be different from that illustrated in FIG. 12D. A plurality of protrusions PRT may be defined on the first horizontal line HBRS1'. For example, among the protrusions PRT of the first horizontal line HBRS1 illustrated in FIG. 12D, the protrusions PRT overlapping the first-second connecting electrodes CN1-2 illustrated in FIG. 13 may be omitted from the first horizontal line HBRS1'. For example, portions from which the protrusions PRT are omitted are illustrated by circular broken lines in FIG. 16A.

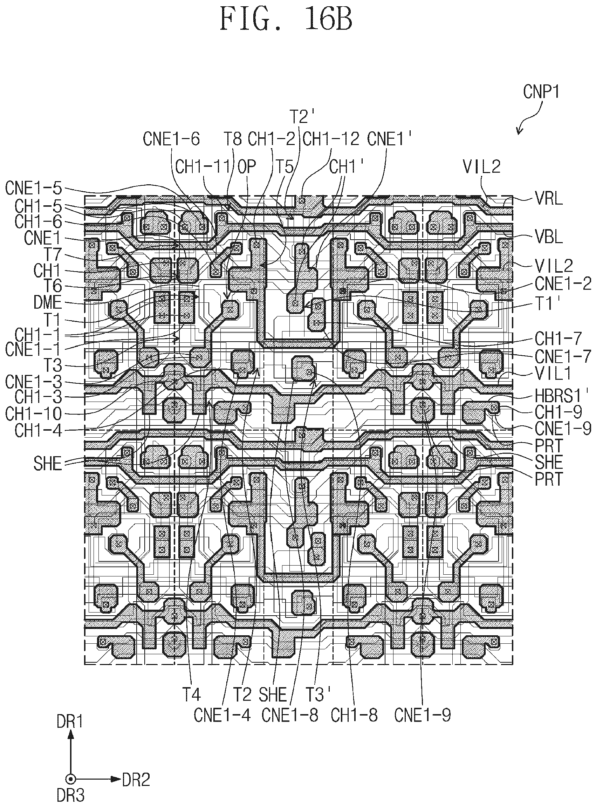

FIG. 16B may correspond to the plan view of FIG. 12G but for another embodiment. Int he embodiment of FIG. 16B, some of the first connecting electrodes CNE1-9 may be omitted. For example, among the first connecting electrodes CNE1-9 illustrated in FIG. 12G, the first-second connecting electrodes CN1-2 illustrated in FIG. 13 may be omitted in FIG. 16B.

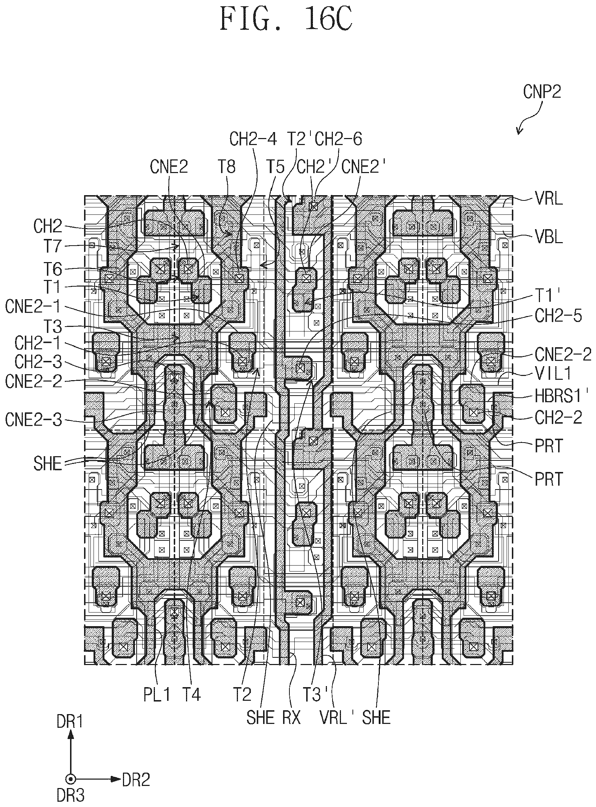

FIG. 16C may correspond to the plan view of FIG. 12H but for another embodiment. In the embodiment of FIG. 16C, some of the second connecting electrodes CNE2-2 may be omitted. For example, among the second connecting electrodes CNE2-2 illustrated in FIG. 12H, the second-second connecting electrodes CN2-2 illustrated in FIG. 13 may be omitted in FIG. 16C.

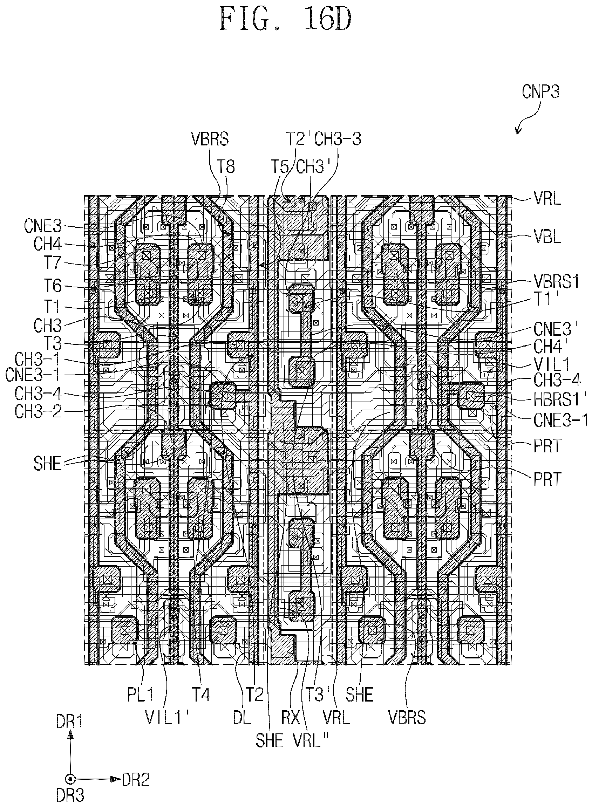

FIG. 16D may correspond to the plan view of FIG. 12I but for another embodiment. In the embodiment of FIG. 16D, some of the third connecting electrodes CNE3-1 may be omitted. For example, among the third connecting electrodes CNE3-1 illustrated in FIG. 12I, the third-second connecting electrodes CN3-2 illustrated in FIG. 13 may be omitted in FIG. 16D.

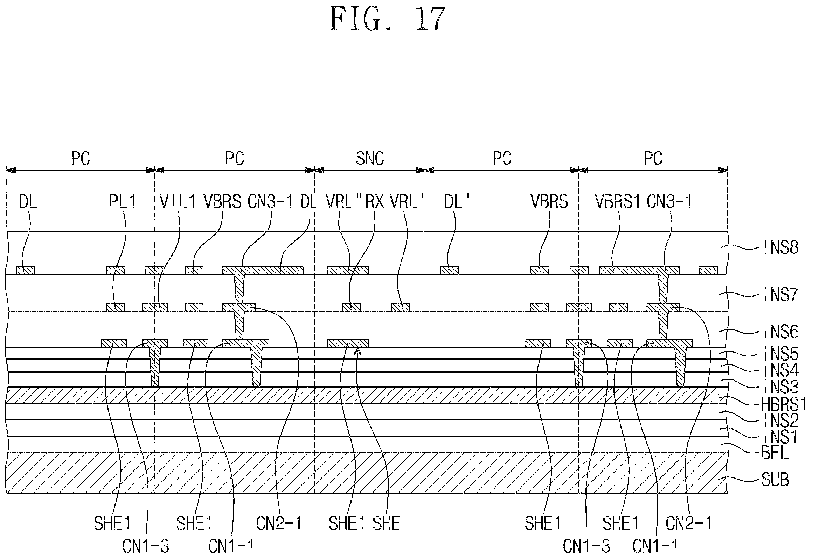

FIG. 17 is a view illustrating a sectional configuration of the first horizontal line and the electrodes connected to the first horizontal line illustrated in FIG. 16D.

FIG. 17 may be a sectional view corresponding to FIG. 13. The following description will be focused on components different from the components illustrated in FIG. 13.

Referring to FIGS. 13, 16D, and 17, the first-second connecting electrode CN1-2, the second-second connecting electrode CN2-2, and the third-second connecting electrode CN3-2 illustrated in FIG. 13 may be omitted in FIG. 17. In this case, parasitic capacitors capable of being formed by the first-second, second-second, and third-second connecting electrodes CN1-2, CN2-2, and CN3-2 and neighboring data lines DL' may be removed.

For example, when it is assumed that the first-second, second-second, and third-second connecting electrodes CN1-2, CN2-2, and CN3-2 exist, the reference numerals of the data lines adjacent to the first-second, second-second, and third-second connecting electrodes CN1-2, CN2-2, and CN3-2 are illustrated as DL'.

When the first-second, second-second, and third-second connecting electrodes CN1-2, CN2-2, and CN3-2 are used, parasitic capacitors formed by the first-second, second-second, and third-second connecting electrodes CN1-2, CN2-2, and CN3-2 and the data lines DL' may affect the sensing signal RS of the receiving line RX. However, in the embodiment of the present disclosure, the first-second, second-second, and third-second connecting electrodes CN1-2, CN2-2, and CN3-2 may be omitted, and thus the above-described parasitic capacitors may be removed.

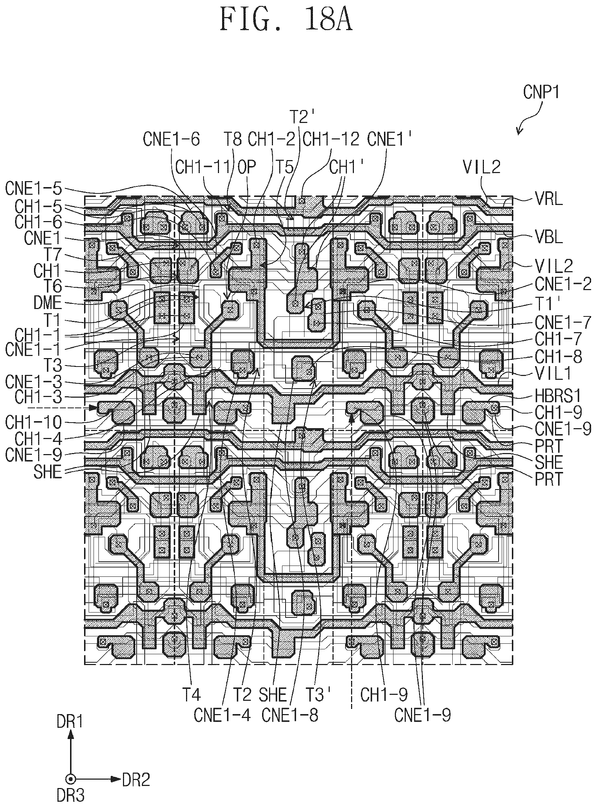

FIGS. 18A to 18C are views illustrating a modified embodiment of the layout illustrated in FIGS. 12A to 12I.

Hereinafter, components illustrated in FIGS. 18A to 18C will be described. The following description will be focused on components different from the components illustrated in FIGS. 12A to 12I.

FIG. 18A may correspond to the plan view of FIG. 12G but for another embodiment. A first horizontal line HBRS1 may have the same configuration as the first horizontal line HBRS1 illustrated in FIG. 12D. Accordingly, protrusions PRT that are the same as those of the first horizontal line HBRS1 illustrated in FIG. 12D may be defined on the first horizontal line HBRS 1.

However, the configuration of the first connecting electrodes CNE1-9 may be different. The first contact holes CH1-9 may not be defined in some of the first connecting electrodes CNE1-9. For example, the first contact holes CH1-9 may not be defined in the first connecting electrodes CNE1-9 corresponding to the first-second connecting electrodes CN1-2 illustrated in FIG. 13 among the first connecting electrodes CNE1-9 illustrated in FIG. 12G. Accordingly, the first connecting electrodes CNE1-9 corresponding to the first-second connecting electrodes CN1-2 may not be connected to the first horizontal line HBRS 1.

For example, portions from which the first contact holes CH1-9 are omitted are indicated by dotted arrows.

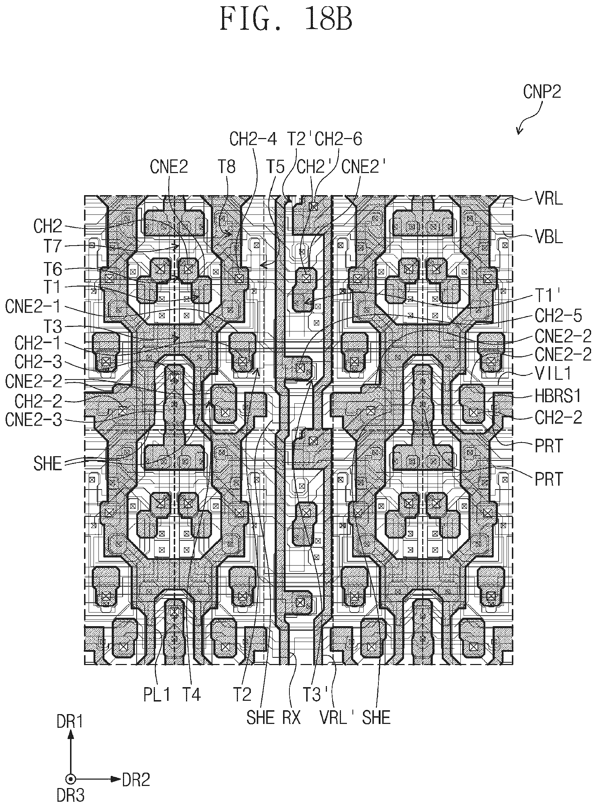

FIG. 18B may correspond to the plan view of FIG. 12H but for another embodiment. However, some of the second connecting electrodes CNE2-2 may be integrally formed with the first power line PL1. For example, among the second connecting electrodes CNE2-2 illustrated in FIG. 12H, the second connecting electrodes CNE2-2 corresponding to the second-second connecting electrodes CN2-2 illustrated in FIG. 13 may be integrally formed with the first power line PL1.

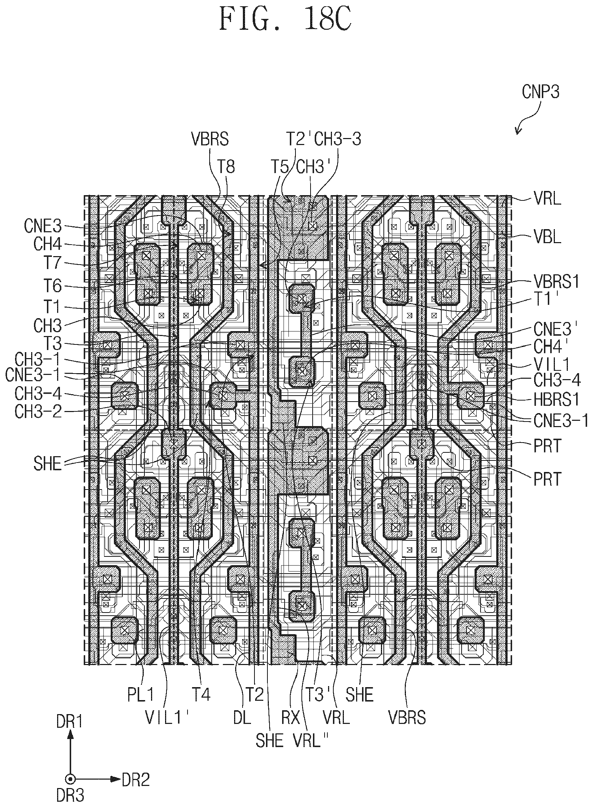

Referring to FIG. 18C, FIG. 18C may correspond to the plan view of FIG. 12I. FIG. 18C may be the same as FIG. 12I.

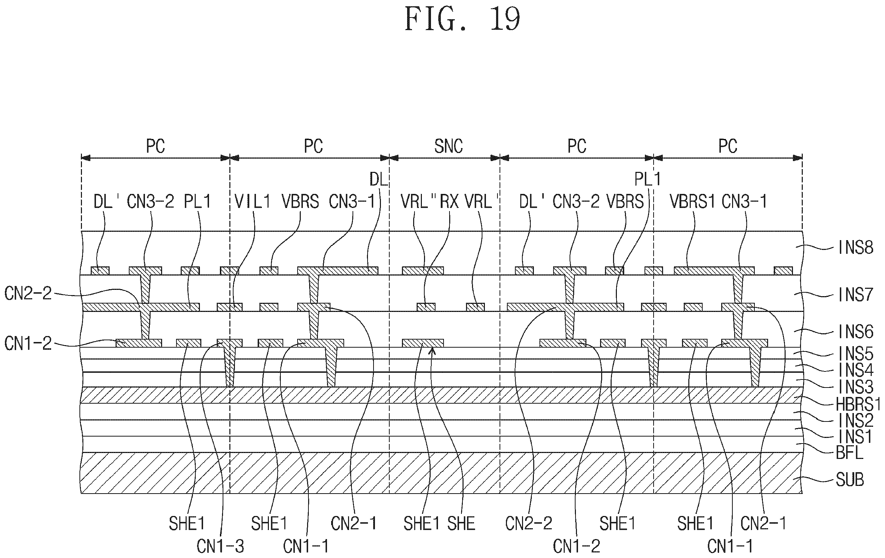

FIG. 19 is a view illustrating a sectional configuration of the first horizontal line and the electrodes connected to the first horizontal line illustrated in FIG. 18C.

FIG. 19 may be a sectional view corresponding to FIG. 13. The following description will be focused on components different from the components illustrated in FIG. 13.

Referring to FIGS. 13, 18C, and 19, the first-second connecting electrodes CN1-2 illustrated in FIG. 19 may not be connected to the first horizontal line HBRS1. The second-second connecting electrodes CN2-2 may be connected to the first-second connecting electrodes CN1-2, respectively, and the third-second connecting electrodes CN3-2 may be connected to the second-second connecting electrodes CN2-2, respectively.

The first power line PL1 may be adjacent to the second-second connecting electrodes CN2-2 and may be integrally formed with the second-second connecting electrodes CN2-2. For example, the second-second connecting electrodes CN2-2 may extend from the first power line PL1. The second-second connecting electrodes CN2-2 may be defined as the first power line PL1.

The first power line PL1 may be disposed to overlap a data line DL'. The first voltage ELVDD applied to the first power line PL 1 may be a constant voltage. The first power line PL1 may be disposed to overlap the data line DL' and may perform a function similar to that of the shielding electrode SHE. The first power line PL1 adjacent to the receiving line RX may be disposed to overlap the data line DL' and may block an influence of the data voltage VD of the data line DL' on the receiving line RX.

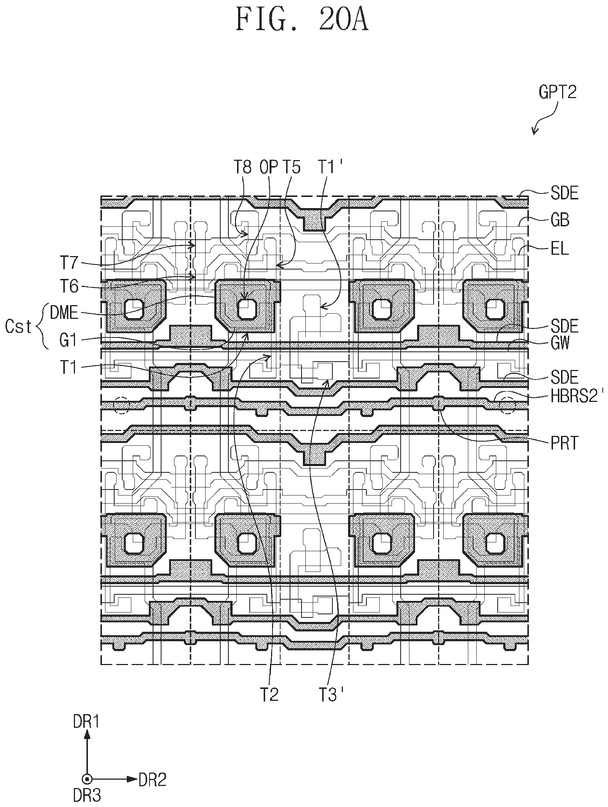

FIGS. 20A to 20D are views illustrating a modified embodiment of the layout illustrated in FIGS. 14A to 14D.

Hereinafter, components illustrated in FIGS. 20A to 20D will be described. The following description will be focused on components different from the components illustrated in FIGS. 14A to 14D.

FIG. 20A may correspond to the plan view of FIG. 14A but for another embodiment. In the embodiment of FIG. 20A, a configuration of a second horizontal line HBRS2' may be different from that illustrated in FIG. 14A. A plurality of protrusions PRT may be defined on the second horizontal line HBRS2'. For example, among the protrusions PRT of the second horizontal line HBRS2 illustrated in FIG. 14A, the protrusions PRT overlapping the first-fifth connecting electrodes CN1-5 illustrated in FIG. 15 may be omitted from the second horizontal line HBRS2'. Portions from which the protrusions PRT are omitted are illustrated by circular broken lines.

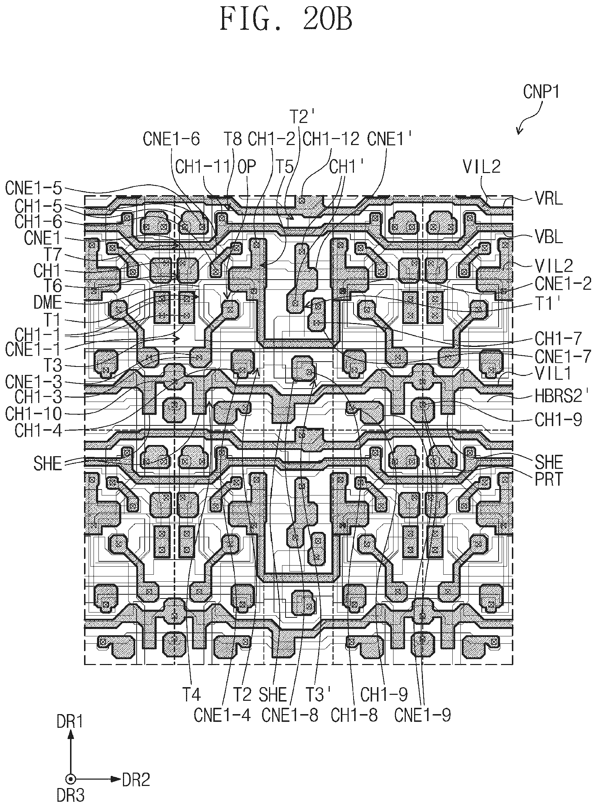

FIG. 20B may correspond to the plan view of FIG. 14B but for another embodiment. However, some of the first connecting electrodes CNE1-9 may be omitted. For example, among the first connecting electrodes CNE1-9 illustrated in FIG. 14B, the first-fifth connecting electrodes CN1-5 illustrated in FIG. 15 may be omitted in FIG. 20B.

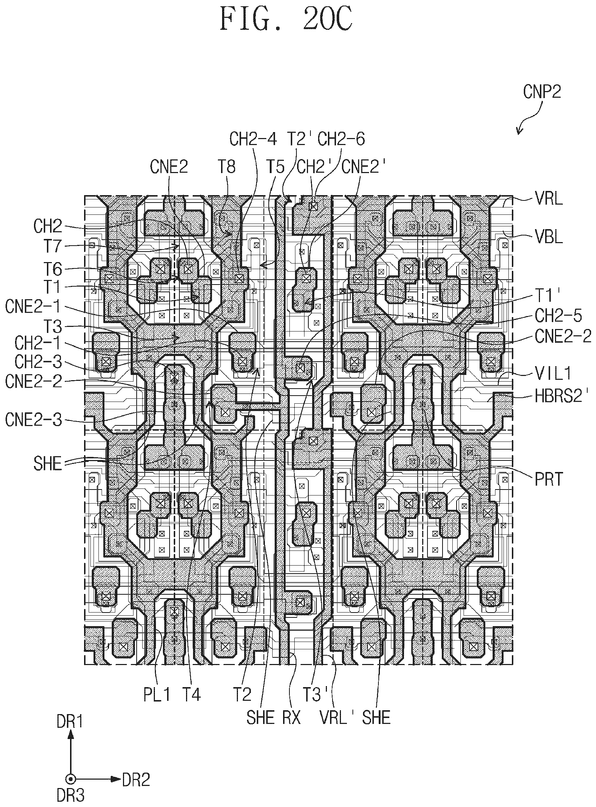

FIG. 20C may correspond to the plan view of FIG. 14C but for another embodiment. In the embodiment of FIG. 20C, some of the second connecting electrodes CNE2-2 may be omitted. For example, among the second connecting electrodes CNE2-2 illustrated in FIG. 14C, the second-fourth connecting electrodes CN2-4 illustrated in FIG. 15 may be omitted in FIG. 20C.

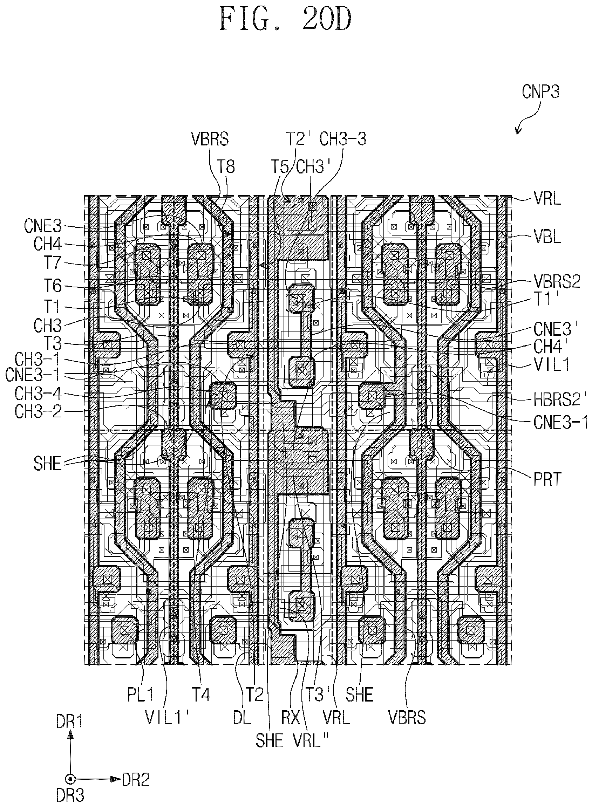

Referring to FIG. 20D, FIG. 20D may correspond to the plan view of FIG. 14D. However, some of the third connecting electrodes CNE3-1 may be omitted. For example, among the third connecting electrodes CNE3-1 illustrated in FIG. 14D, the third-fourth connecting electrodes CN3-4 illustrated in FIG. 15 may be omitted in FIG. 20D.

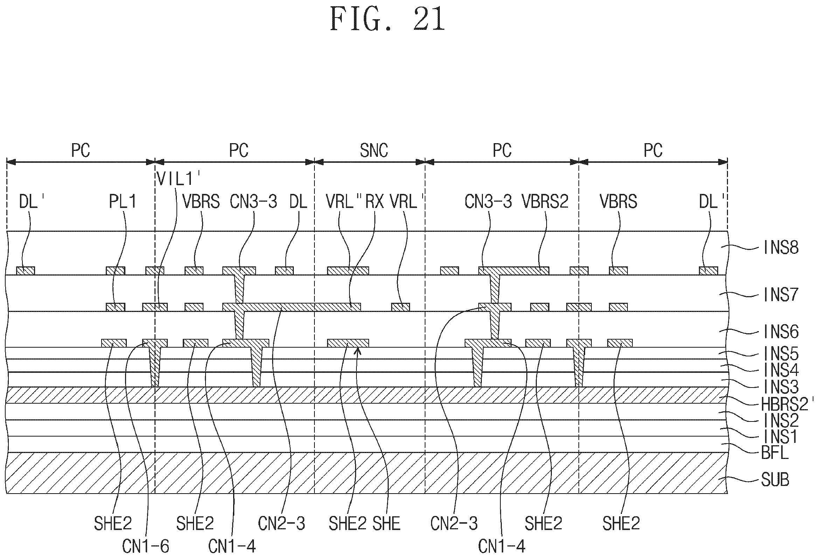

FIG. 21 is a view illustrating a sectional configuration of the second horizontal line and the electrodes connected to the second horizontal line illustrated in FIG. 20D.

FIG. 21 may be a sectional view corresponding to FIG. 15. The following description will be focused on components different from the components illustrated in FIG. 15.

Referring to FIGS. 15, 20D, and 21, the first-fifth connecting electrode CN1-5, the second-fourth connecting electrode CN2-4, and the third-fourth connecting electrode CN3-4 illustrated in FIG. 15 may be omitted in FIG. 21. In this case, parasitic capacitors capable of being formed by the first-fifth, second-fourth, and third-fourth connecting electrodes CN1-5, CN2-4, and CN3-4 and neighboring data lines DL' may be removed.

When the first-fifth, second-fourth, and third-fourth connecting electrodes CN1-5, CN2-4, and CN3-4 are used, a coupling phenomenon depending on parasitic capacitors formed by the first-fifth, second-fourth, and third-fourth connecting electrodes CN1-5, CN2-4, and CN3-4 and the data lines DL' may affect the sensing signal RS output through the second horizontal line HBRS2'.

However, in the embodiment of the present disclosure, the first-fifth, second-fourth, and third-fourth connecting electrodes CN1-5, CN2-4, and CN3-4 may be omitted, and thus the above-described coupling phenomenon depending on the parasitic capacitors may be prevented.

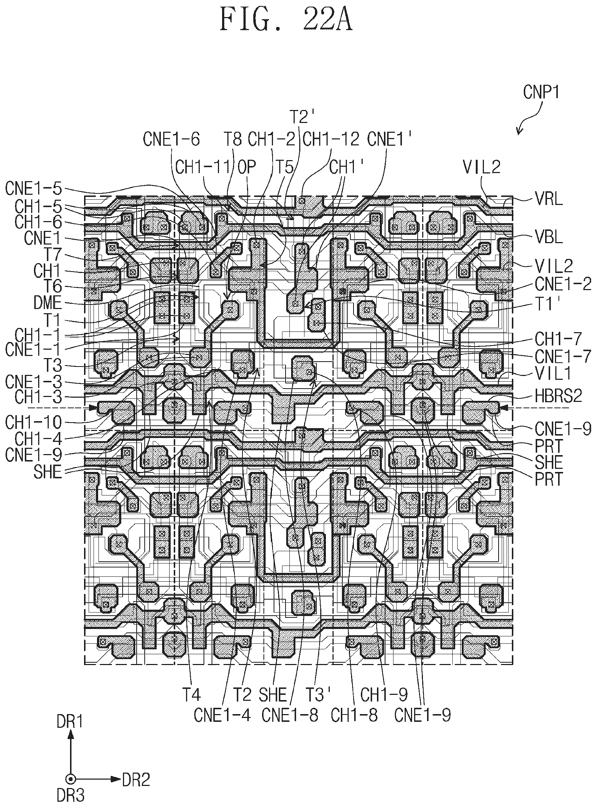

FIGS. 22A to 22C are views illustrating a modified embodiment of the layout illustrated in FIGS. 14A to 14D.

Hereinafter, components illustrated in FIGS. 22A to 22C will be described. The following description will be focused on components different from the components illustrated in FIGS. 14A to 14D.

FIG. 22A may correspond to the plan view of FIG. 14B but for another embodiment. A second horizontal line HBRS2 may have the same configuration as the second horizontal line HBRS2 illustrated in FIG. 14A. Accordingly, protrusions PRT may be defined on the second horizontal line HBRS2.

However, the configuration of the first connecting electrodes CNE1-9 may be different. The first contact holes CH1-9 may not be defined in some of the first connecting electrodes CNE1-9. For example, the first contact holes CH1-9 may not be defined in the first connecting electrodes CNE1-9 corresponding to the first-fifth connecting electrodes CN1-5 illustrated in FIG. 15 among the first connecting electrodes CNE1-9 illustrated in FIG. 14B. Accordingly, the first connecting electrodes CNE1-9 corresponding to the first-fifth connecting electrodes CN1-5 may not be connected to the second horizontal line HBRS2.

For example, portions from which the first contact holes CH1-9 are omitted are indicated by dotted arrows.

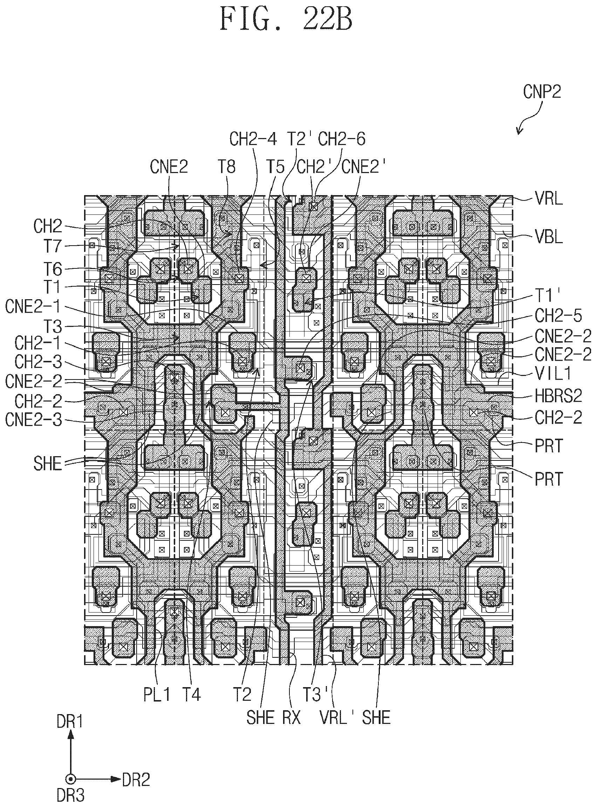

Referring to FIG. 22B, FIG. 22B may correspond to the plan view of FIG. 14C. However, some of the second connecting electrodes CNE2-2 may be integrally formed with the first power line PL1. For example, among the second connecting electrodes CNE2-2 illustrated in FIG. 14C, the second connecting electrodes CNE2-2 corresponding to the second-fourth connecting electrodes CN2-4 illustrated in FIG. 15 may be integrally formed with the first power line PL1.

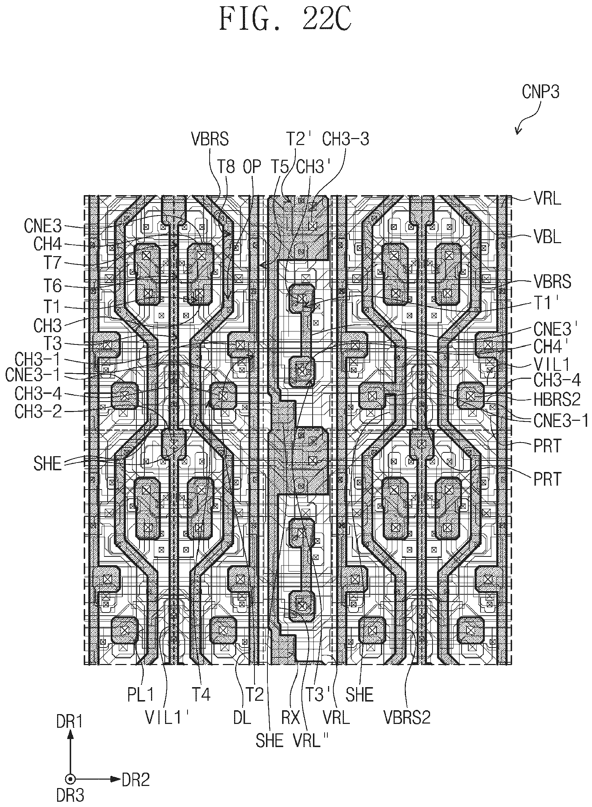

FIG. 22C may correspond to the plan view of FIG. 14D but for another embodiment. The third connecting pattern CNP3 of the embodiment depicted in FIG. 22C may be the same as the third connecting pattern CNP3 of the embodiment in FIG. 14D.

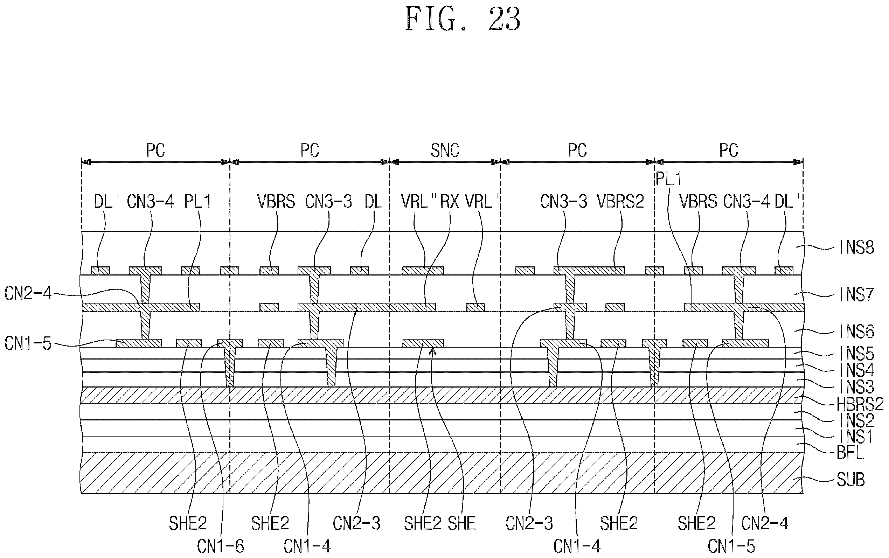

FIG. 23 is a view illustrating a sectional configuration of the second horizontal line and the electrodes connected to the second horizontal line illustrated in FIG. 22C.

FIG. 23 may be a sectional view corresponding to FIG. 15. The following description will be focused on components different from the components illustrated in FIG. 15.

Referring to FIGS. 15, 22C, and 23, the first-fifth connecting electrodes CN1-5 illustrated in FIG. 23 may not be connected to the second horizontal line HBRS2. The second-fourth connecting electrodes CN2-4 may be connected to the first-fifth connecting electrodes CN1-5, respectively, and the third-fourth connecting electrodes CN3-4 may be connected to the second-fourth connecting electrodes CN2-4, respectively.

The first power line PL1 may be adjacent to the second-fourth connecting electrodes CN2-4 and may be integrally formed with the second-fourth connecting electrodes CN2-4. For example, the second-fourth connecting electrodes CN2-4 may extend from the first power line PL1. The second-fourth connecting electrodes CN2-4 may be defined as the first power line PL1.

The first power line PL1 may be disposed to overlap data lines DL'. The first power line PL1, to which a constant voltage is applied, may block an influence of the data voltage VD of the data lines DL' on the sensing signal RX of the second horizontal line HBRS2.

As discussed, embodiments can provide a display device comprising: a first-first line extending in a first direction; a first-second line extending in a second direction crossing the first direction and connected to the first-first line; a data line extending in the first direction and connected to the first-second line; a pixel connected to the data line; a receiving line extending in the first direction; a sensor connected to the receiving line; and a shielding electrode disposed above the first-second line and overlapping the first-second line and the receiving line.

The first-first line may be a vertical line. The first-second line may be a horizontal line.

There may be a plurality of first lines and second lines.

The first-first lines may be connected to a data driver, and the first-second lines may be connected to the first-first lines, respectively. In addition, the first-second lines may be connected to the data lines in a border region of the display. The data lines adjacent to the border region of the display may be connected to the data driver through the first-second lines and the first-first lines.

Embodiments can provide a display device comprising: a first-first line extending in a first direction; a first-second line extending in a second direction crossing the first direction, the first-second line being disposed below the first-first line and connected to the first-first line; a data line extending in the first direction, the data line being disposed in the same layer as the first-first line and connected to the first-second line; a pixel connected to the data line; a receiving line extending in the first direction and disposed in a layer different from the layer in which the data line is disposed; a sensor connected to the receiving line; and a shielding electrode disposed above the first-second line and overlapping the first-second line.

Embodiments can provide a display device comprising: a first-first line; a first-second line crossing the first-first line and connected to the first-first line; a data line crossing the first-second line and connected to the first-second line; a pixel connected to the data line; a receiving line disposed in a layer different from a layer in which the first-second line is disposed; a sensor connected to the receiving line; and a plurality of shielding electrodes disposed in a layer between the first-second line and the receiving line and overlapping the first-second line.

According to the embodiments of the present disclosure, the shielding electrode, to which a constant voltage is applied, may be disposed between the horizontal line to which the data line is connected and the receiving line. Accordingly, the signal-to-noise ratio of the sensing signal output through the receiving line may be improved. As a result, the sensing sensitivity of the sensor may be improved.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device comprising:
a first-first line extending in a first direction;
a first-second line extending in a second direction crossing the first direction and connected to the first-first line;
a data line extending in the first direction and connected to the first-second line;
a pixel connected to the data line;
a receiving line extending in the first direction;
a sensor connected to the receiving line; and
a shielding electrode disposed above the first-second line and overlapping the first-second line and the receiving line.

2. The display device of claim 1, wherein the first-first line and the data line are disposed in the same layer, and the receiving line is disposed on a layer below the first-first line and the data line.

3. The display device of claim 2, wherein the first-second line is disposed below the receiving line;
optionally wherein the shielding electrode is disposed in a layer located between the receiving line and the first-second line.

4. The display device of any one of claims 1 to 3, further comprising:
a plurality of first-first connecting electrodes disposed over the first-second line and connected to the first-second line; and
a plurality of second-first connecting electrodes disposed above the first-first connecting electrodes and connected to the first-first connecting electrodes,
wherein the data line and the first-first line are connected to the second-first connecting electrodes.

5. The display device of claim 4, further comprising:
a plurality of first-second connecting electrodes disposed above the first-second line and connected to the first-second line;
a plurality of second-second connecting electrodes disposed above the first-second connecting electrodes and connected to the first-second connecting electrodes;
a plurality of third-first connecting electrodes extending from the data line and the first-first line, the plurality of third-first connecting electrodes being disposed above the second-first connecting electrodes and connected to the second-first connecting electrodes; and
a plurality of third-second connecting electrodes disposed above the second-second connecting electrodes and connected to the second-second connecting electrodes.

6. The display device of claim 5, further comprising:
a plurality of first-third connecting electrodes disposed above the first-second line and connected to the first-second line,
wherein the second-first and second-second connecting electrodes and the third-first and third-second connecting electrodes are not disposed above the first-third connecting electrodes;
optionally wherein the shielding electrode is disposed in the same layer as the first-first, first-second, and first-third connecting electrodes, the receiving line is disposed in the same layer as the second-first and second-second connecting electrodes, and the data line and the first-first line are disposed in the same layer as the third-first and third-second connecting electrodes;
optionally wherein the shielding electrode includes a plurality of first shielding electrodes disposed between the first-first, first-second, and first-third connecting electrodes.

7. The display device of any one of claims 1 to 6, further comprising:
an initialization line connected to the pixel,
wherein the shielding electrode protrudes from the initialization line.

8. The display device of any one of claims 1 to 7, further comprising:
a reset line disposed above the receiving line and adjacent to the data line.

9. The display device of any one of claims 1 to 8, further comprising:
a plurality of first-first connecting electrodes disposed above the first-second line and connected to the first-second line;
a plurality of first-second connecting electrodes disposed above the first-second line;
a plurality of second-first connecting electrodes disposed above the first-first connecting electrodes and connected to the first-first connecting electrodes;
a plurality of second-second connecting electrodes disposed above the first-second connecting electrodes and connected to the first-second connecting electrodes; and
a first power line adjacent to the second-second connecting electrodes, the first power line being integrally formed with the second-second connecting electrodes,
wherein the data line and the first-first line are connected to the second-first connecting electrodes;
optionally wherein the first-second connecting electrodes are spaced apart from the first-second line.

10. The display device of any one of claims 1 to 9, further comprising:
a second-first line extending in the first direction; and
a second-second line extending in the second direction and connected to the second-first line,
wherein the second-second line is connected to the receiving line.

11. The display device of claim 10, further comprising:
a plurality of first-fourth connecting electrodes disposed above the second-second line and connected to the second-second line; and
a plurality of second-third connecting electrodes disposed above the first-fourth connecting electrodes and connected to the first-fourth connecting electrodes,
wherein the receiving line is disposed in the same layer as the second-third connecting electrodes, and
wherein among the second-third connecting electrodes, a second-third connecting electrode corresponding to the receiving line extends from the receiving line.

12. The display device of claim 11, further comprising:
a plurality of first-fifth connecting electrodes disposed above the second-second line and connected to the second-second line;
a plurality of first-sixth connecting electrodes disposed above the second-second line and connected to the second-second line;
a plurality of second-fourth connecting electrodes disposed above the first-fifth connecting electrodes and connected to the first-fifth connecting electrodes;
a plurality of third-third connecting electrodes disposed above the second-third connecting electrodes and connected to the second-third connecting electrodes; and
a plurality of third-fourth connecting electrodes disposed above the second-fourth connecting electrodes and connected to the second-fourth connecting electrodes,
wherein the second-first line is disposed in the same layer as the third-third connecting electrodes, and
wherein among the third-third connecting electrodes, a third-third connecting electrode connected to a second-third connecting electrode not extending from the receiving line extends from the second-first line;
optionally wherein the shielding electrode includes a plurality of second shielding electrodes disposed between the first-fourth, first-fifth, and first-sixth connecting electrodes.

13. The display device of any one of claims 10 to 12, further comprising:
a plurality of first-fourth connecting electrodes disposed above the second-second line and connected to the second-second line;
a plurality of first-fifth connecting electrodes disposed above the second-second line and spaced apart from the second-second line;
a plurality of second-third connecting electrodes disposed above the first-fourth connecting electrodes and connected to the first-fourth connecting electrodes;
a plurality of second-fourth connecting electrodes disposed above the first-fifth connecting electrodes and connected to the first-fifth connecting electrodes; and
a first power line adjacent to the second-fourth connecting electrodes, the first power line being integrally formed with the second-fourth connecting electrodes,
wherein the receiving line is disposed in the same layer as the second-third connecting electrodes,
wherein among the second-third connecting electrodes, a second-third connecting electrode corresponding to the receiving line extends from the receiving line, and
wherein the second-first line is connected to a second-third connecting electrode that is spaced apart from the receiving line.

14. The display device of any one of claims 1 to 13, wherein the first-second line is disposed below the first-first line, the data line is disposed in the same layer as the first-first line, and the receiving line is disposed in a layer different from the layer in which the data line is disposed.

15. A display device comprising:
a first-first line;
a first-second line crossing the first-first line and connected to the first-first line;
a data line crossing the first-second line and connected to the first-second line;
a pixel connected to the data line;
a receiving line disposed in a layer different from a layer in which the first-second line is disposed;
a sensor connected to the receiving line; and
a plurality of shielding electrodes disposed in a layer between the first-second line and the receiving line and overlapping the first-second line.
